# EUROPEAN PATENT APPLICATION

(11) **EP 1 811 585 A1**
(43) Date of publication of application: **25.07.2007**
(21) Application number: 05782401.3
(22) Date of filing: 12.09.2005
(51) Int. Cl.: H01L 51/00

(54) **ORGANIC ELECTROLUMINESCENT ELEMENT**

(30) Priority: 10.11.2004 JP 2004327019
(71) Applicant: IDEMITSU KOSAN CO., LTD., Tokyo 100-8321 (JP)
(72) Inventor: FUNAHASHI, Masakazu, 2990293 (JP); ITO, Mitsunori, 2990293 (JP); KAWAMURA, Hisayuki, 2990293 (JP)
(74) Representative: Gille Hrabal Struck Neidlein Prop Roos
(86) International application number: PCT/JP2005/016749
(87) International publication number: WO 2006/051649

(57) **Abstract**

An organic electroluminescence device exhibiting an excellent heat resistance, a prolonged lifetime and a great efficiency of light emission and generating a light emission ranging from blue light to red light. The organic electroluminescence device comprising one or more thin-film layers which comprises at least a light emitting layer and are interposed between a cathode and an anode, wherein the light emitting layer comprises an amine compound with a specific structure and a fluorene-based compound with a specific structure.

## Description

### TECHNICAL FIELD

The present invention relates to an organic electroluminescence (EL) element, more particularly, to an organic EL device that exhibits an excellent heat resistance, a prolonged lifetime and a great efficiency of light emission and to produce emission in the range of from blue light to red light.

### BACKGROUND ART

An organic EL device is a spontaneous light emitting device which utilizes the principle that a fluorescent substance emits light by energy of recombination of holes injected from an anode and electrons injected from a cathode when an electric field is applied. Since C. W. Tang of Eastman Kodak Company (C. W. Tang and S. A. Vanslyke, Applied Physics Letters, Volume 51, Page 913, 1987, etc) reported an organic EL device of the laminate type driven under a low electric voltage, many studies have been conducted on organic EL devices using organic materials as the constituting materials.
Tang et al. used tris(8-hydroxyquinolinol)aluminum for the light emitting layer and used a triphenyldiamine derivative for the hole transporting layer. Advantages of the laminate structure are that the efficiency of hole injection into the light emitting layer can be increased, that the efficiency of forming excited particles which are formed by blocking and recombining electrons injected from the cathode can be increased, and that excited particles formed within the light emitting layer can be enclosed. As the structure of the organic EL device, a two-layered structure having a hole transporting (injecting) layer and an electron transporting and light emitting layer and a three-layered structure having a hole-transporting (injecting) layer, a light emitting layer and an electron transporting (injecting) layer are well known. To increase the efficiency of recombination of injected holes and electrons in the devices of the laminate type, the structure of the device and the process for forming the device have been studied.
As the light emitting material, chelate complexes such as tris(8-quinolinolato)aluminum, coumarin derivatives, tetraphenyl-butadiene derivatives, bisstyrylarylene derivatives and oxadiazole derivatives and the like are known. It is reported that light emission in the visible region in the range of from blue light to red light can be obtained by employing derivatives of these light emitting materials, and development of a device exhibiting color images is expected (For example, the patent literatures 1 to 3, etc.)

In recent years, the many studies to use energy in a triplet state for EL emission have been conducting by using phosphorescent compounds as a light emitting material. It has been reported by the group of Princeton University that the organic EL device using the iridium complexes serving as the light emitting material exhibited high luminous efficiency (the non-patent literature 1). Further, other than the organic EL devices using the aforementioned low molecule materials, the organic EL devices using the conjugated polymers were reported by the group of The University of Cambridge (the non-patent literature 2). This report confirmed light emission at the monolayer of a film formed by a coating system of polyphenylene vinylene (PPV).
As just described above, the recent development of organic EL devices has been significant and it is possible to realize high luminance at low applied voltage, multiplicity of wavelength of the emitted light, high-speed response, and thin and light-weight device, therefore the features suggest a possibility of a wide variety of application thereof.
For example, the devices employed bisanthracene derivatives serving as a light emitting material were disclosed in the patent literatures 4 and 5. The bisanthracene was used for a blue light emitting material, however it has been inadequate for commercial use since the efficiency or the lifetime thereof has not yet reached to a level of practical application. In addition, the devices using symmetric pyrene derivatives were disclosed in the patent literatures 6 to 9. The improvement of a lifetime thereof has been desired, although such symmetric pyrene derivatives were employed as serving a blue light emitting material. In particular, a device comprising a combination of condensed polycyclic aromatic groups having 3 or more benzene rings linked directly to a fluorene moiety serving as a host material and a material of diamine having a fluorene bone structure serving as a dopant was disclosed in the patent literature 9, however there is a problem of a short lifetime thereof. The device using the aminoanthracene derivative serving as a green light emitting material was disclosed in the patent literature 10. However, the glass transition temperature of the material is so low that the heat resistance of the organic EL device using it was low, and a long lifetime and high efficient emission device was not obtained. The red light emitting device having a light emitting layer added by naphthacene or pentacene derivatives was disclosed in the patent literature 11, and it exhibited excellence in red color purity, but 1,500 hours of the half lifetime of luminance thereof was inadequate due to the very high applied voltage of 11 V The red light emitting device having a light emitting layer added by an amine-based aromatic compound was disclosed in the patent literature 12, the light emitting device had the color purity of CIE chromasity (0.64, 0.33), but the driving voltage was not less than 10 V, which means the high driving voltage. Although the device having a light emitting layer added by the aza-fluoranthen compound was disclosed in the patent literature 13, the light was emitted in the range of from yellow to green and a red light emitting was not realized adequately.

Patent literature 1: Japanese Patent Application Laid-Open No. Heisei 8(1996)-239655
Patent literature 2: Japanese Patent Application Laid-Open No. Heisei 7(1995)-138561
Patent literature 3: Japanese Patent Application Laid-Open No. Heisei 3(1991)-200289
Patent literature 4: the description of USP3008897
Patent literature 5: Japanese Patent Application Laid-Open No. Heisei 8(1996)-12600
Patent literature 6: Japanese Patent Application Laid-Open No. 2001-118682
Patent literature 7: Japanese Patent Application Laid-Open No. 2002-63988
Patent literature 8: Japanese Patent Application Laid-Open No. 2004-75567
Patent literature 9: Japanese Patent Application Laid-Open No. 2004-83481
Patent literature 10: Japanese Patent Application Laid-Open No. 2001-207167
Patent literature 11: Japanese Patent Application Laid-Open No. Heisei 8(1996)-311442
Patent literature 12: Japanese Patent Application Laid-Open No. 2001-81451
Patent literature 13: Japanese Patent Application Laid-Open No. 2001-160489
Non-patent literature 1: Nature, 395,151 (1998)
Non-patent literature 2: Nature, 345,539 (1990)

### DESCLOSURE OF THE INVENTION

The present invention has been conceived so as to solve the aforementioned problems and has an objective of providing an organic EL device to exhibit an excellent heat resistance and a long lifetime, and also which can emit light in the range of from blue light to red light at high emission efficiency.

The present inventors have carried out extensive studies with an aim toward developing the aforementioned objective and have found that the aforementioned objective can be attained through employment of a fluorene-based compound represented by any of the following general formula (B) and an amine compound represented by any of the following general formula (A) serving as a light emission material. The present invention has been accomplished on the basis of the findings and information.

Namely, the present invention provides an organic electroluminescence device comprising one or more thin-film layers which comprise at least a light emitting layer and are interposed between a cathode and an anode, wherein the light emitting layer comprises an amine compound represented by any of the following general formula (A):

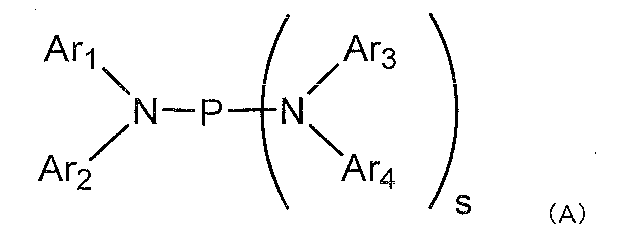

wherein P represents a substituted or unsubstituted aromatic hydrocarbon group having 6 to 40 ring atoms, a substituted or unsubstituted heterocyclic group having 3 to 40 ring atoms, or a substituted or unsubstituted styryl group; each of Ar₁ to Ar₄ represents independently a substituted or unsubstituted aromatic hydrocarbon group having 6 to 40 ring carbon atoms, or a substituted or unsubstituted heterocyclic group having 3 to 40 ring atoms and s represents an integer of from 0 to 4; and a fluorene-based compound represented by any of the following general formula (B).

(A-X) m-(FL-B) n (B)

wherein m represents an integer of from 0 to 10 and n represents an integer of from 1 to 10;
A represents a substituted or unsubstituted aromatic hydrocarbon group having 6 to 50 ring carbon atoms, a substituted or unsubstituted heterocyclic group having 6 to 50 ring atoms, a substituted or unsubstituted alkyl group or alkylene group having 1 to 50 carbon atoms, or a substituted or unsubstituted alkenyl group or alkenylene group having 1 to 50 carbon atoms; and plural numbers of A may be the same with or different from each other when m is 2 or more.
B represents a single bond, a hydrogen atom, a substituted or unsubstituted aromatic hydrocarbon group having 6 to 50 ring carbon atoms, a substituted or unsubstituted alkyl group or alkylene group having 1 to 50 carbon atoms, or a substituted or unsubstituted alkenyl group or alkenylene group having 1 to 50 carbon atoms; and plural numbers of A may be the same with or different from each other when n is 2 or more.
X represents a single bond, a substituted or unsubstituted aromatic hydrocarbon group having 6 to 50 ring carbon atoms, a substituted or unsubstituted alkylene group having 1 to 50 carbon atoms, or a substituted or unsubstituted alkenylene group having 1 to 50 carbon atoms; and plural numbers of X may be the same with or different from each other when m is 2 or more.
FL represents a fluorene-based derivative group or a group made by combining the fluorene-based derivative groups shown by the following general formulae (1) to (6) and plural numbers of FL may be the same with or different from each other when n is 2 or more.

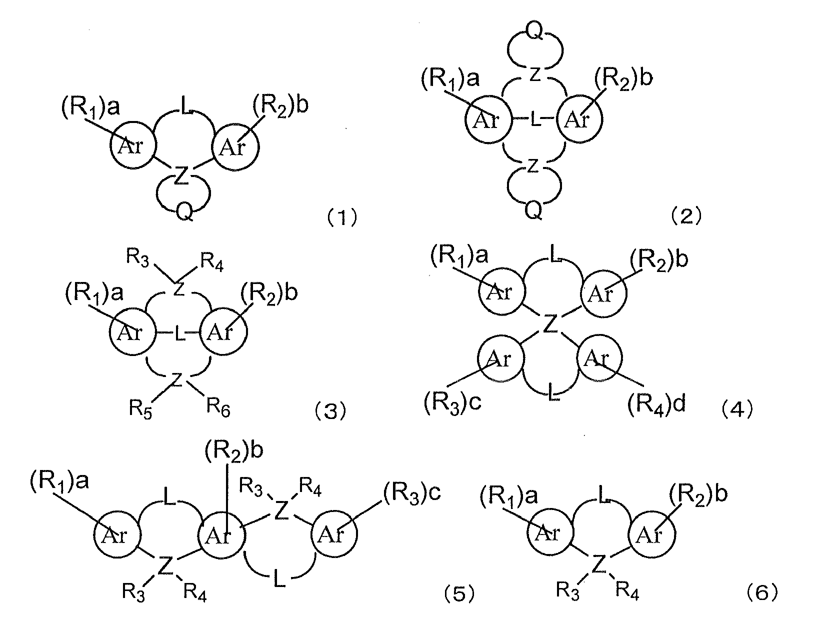

wherein L in the general formulae (1) to (6) represents a single bond, -(CR'R")ₖ-, -(SiR'R")ₖ-, -O-, -CO- or -NR'-;
each of R' and R" represents independently a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group or a hydroxyl group, and the members thereof may linked each other to form a ring structure; k represents an integer of from of 1 to 10 and each of R' and R" may be the same with or different from each other.
Z represents a carbon atom, a silicon atom or a germanium atom.
Q represents a group forming a ring structure and a ring structure constituted by Z -Q may be condensed additionally with a substituted or unsubstituted cycloalkyl group having 3 to 50 ring carbon atoms, a substituted or unsubstituted aromatic hydrocarbon group having 6 to 50 ring carbon atoms, or a substituted or unsubstituted heterocyclic group having 5 to 50 ring atoms.
Ar expresses a ring structure shown by a circle enclosing a symbol Ar, and represents a moiety, which may have a substituent, of cycloalkane having 3 to 20 ring carbon atoms of which a carbon atom may be replaced by a nitrogen atom, an aromatic hydrocarbon group having 6 to 50 ring carbon atoms which may have a substituent, or a heterocyclic group having 5 to 50 ring atoms which may have a substituent; and plural numbers of Ar, if any, may be the same with or different from each other;
Each of R₁ to R₆ represents independently a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 2 to 50 carbon atoms, a carboxyl group, a halogen atom, a cyano group, a nitro group or a hydroxyl group. Plural numbers of R₁ to R₆, if any, may be the same with or different from each other and the adjoining ones among R₁ to R₆ may link each other to form a ring structure.
Each of a to d is an integer of from 0 to 4.

The organic EL devices of the present invention exhibit an excellent heat resistance and a long lifetime and generate light emission in the range of from blue light to red light at high emission efficiency.

### PREFERRED EMBODIMENTS FOR CARRYING OUT THE INVENTION

The present invention provides an organic electroluminescence device comprising one or more thin-film layers which comprise at least a light emitting layer and are interposed between a cathode and an anode, wherein the light emitting layer comprises an amine compound represented by any of the following general formula (A) and a fluorene-based compound represented by any of the following general formula (B).
Firstly, the amine compound represented by the general formula (A) is explained.

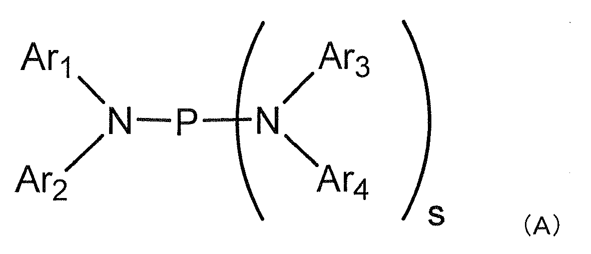

In the general formula (A), P represents a substituted or unsubstituted aromatic hydrocarbon group having 6 to 40 ring carbon atoms, a substituted or unsubstituted heterocyclic group having 3 to 40 ring atoms, or a substituted or unsubstituted styryl group.
As examples for the aromatic hydrocarbon group and the heterocyclic group of the aforementioned P, each of them may include the similar groups to those of the A and B in the aforementioned general formula (B), in particular, the condensed aromatic ring groups having 10 to 40 ring carbon atoms are preferable; examples of which include moieties of naphthalene, phenanthrene, fluoranthene, anthracene, pyrene, perylene, coronene, chrysene, picene, binaphthyl, trinaphthyl, phenyl anthracene, diphenylanthracene, fluorene, triphenylene, rubicene, benzanthracene, dibenzanthracene, acenaphthofluoranthene, tribenzopentaphene, fluoranthenofluoranthene, benzdifluoranthene, benzofluoranthene and, di indeno perylene. Particularly preferable examples include the moieties of naphthalene, phenanthrene, fluoranthene, anthracene, pyrene, perylene, chrysene, phenyl anthracene, diphenylanthracene and the moieties made by combining the above groups.

In the general formula (A), each of Ar₁ to Ar₄ represents independently a substituted or unsubstituted aromatic hydrocarbon group having 6 to 40 ring carbon atoms, or a substituted or unsubstituted heterocyclic group having 3 to 40 ring atoms and s represents an integer of from 0 to 4.
Examples for the aromatic hydrocarbon groups of Ar₁ to Ar₄ include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl) phenyl group, 3-methyl-2-naphthyl group, 4-methyl-1-naphthyl group, 4-methyl-1-anthryl group, 4'-methylbiphenyl-yl group, 4"-t-butyl-p-terphenyl-4-yl group, etc.

Examples for the heterocyclic groups of Ar₁ to Ar₄ include 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-iso indolyl group,2-iso indolyl group, 3-iso indolyl group, 4-iso indolyl group, 5-iso indolyl group, 6-iso indolyl group, 7-iso indolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthrohne-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthrohne- 10-yl group, 1,10-phenanthrohne-2-yl group, 1,10-phenanthroline-3-yl group, 1,10-phenanthroline-4-yl group, 1,10-phenanthroline-5-yl group, 2,9-phenanthrohne-1-yl group, 2,9-phenanthroune-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthrohne- 1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthrohne-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrole-1-yl group, 2-methylpyrrole-3-yl group, 2-methylpyrrole-4-yl group, 2-methylpyrrole-5-yl group, 3-methylpyrrole-1-yl group, 2-t-butylpyrrole-4-yl group, 3-(2-phenylpropyl)pyrrole-1-yl group, 2-methyl-1-indolyl group, 4-methyl-1-indolyl group, 2-methyl-3-indolyl group, 4-methyl-3-indolyl group, 2-t-butyl 1-indolyl group, 4-t-butyl 1-indolyl group, 2-t-butyl 3-indolyl group, 4-t-butyl 3-indolyl group, etc.

The amine compound represented by the general formula (A) may be preferably an amine compound represented by any of the following general formulae (A1), (A2), (A3), (A4) and (A5).

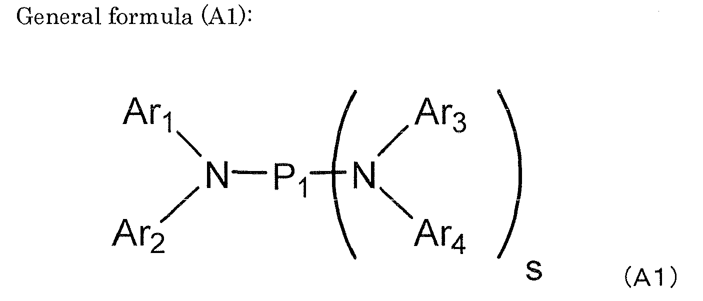

In the general formula (A1), P₁ represents an aromatic hydrocarbon group having 6 to 40 ring carbon atoms and examples thereof include the same as those of the aforementioned P.
Each of Ar₁ to Ar₄ and s in the general formula (A1) represents the similar to the aforementioned.

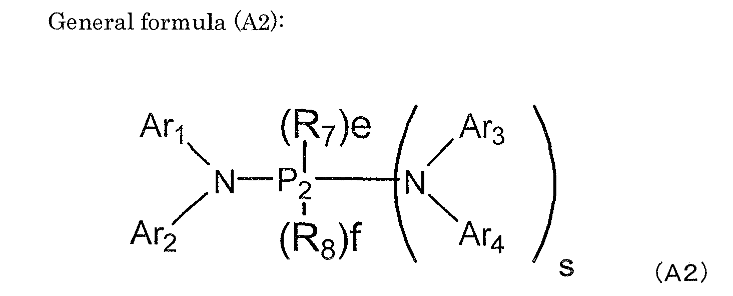

In the general formula (A2), P₂ represents an aromatic hydrocarbon group having 6 to 40 ring carbon atoms and examples thereof include the similar ones to those of the aforementioned P.
In the general formula (A2), each of R₇ and R₈ represents independently a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms.

The alkyl group of the aforementioned R₇ and R₈ includes, for examples, methyl group, ethyl group, propyl group, isopropyl group, butyl group, sec-butyl group, tert-butyl group, pentyl group, hexyl group, heptyl group, octyl group, stearyl group, 2-phenylisopropyl group, trichloromethyl group, trifluoromethyl group, benzyl group, α-phenoxybenzyl group, α, α-dimethylbenzyl group, α, α -methylphenylbenzyl group, α, α-ditrifluoromethylbenzyl group, triphenylmethyl group and α-benzyloxybenzyl group. An aromatic hydrocarbon group of the aforementioned R₇ and R₈ includes, for examples, phenyl group, 2-methylphenyl group, 3-methylphenyl group, 4-methylphenyl group, 4-ethylphenyl group, biphenyl group, 4-methyl biphenyl group, 4-cyclohexylbiphenyl group, terphenyl group, 3,5-dichlorophenyl group, naphtyl group, 5-methylnaphtyl group, anthryl group and pyrenyl group.

The aralkyl group of the aforementioned R₇ and R₈ includes, for examples, benzyl group, 1-phenylethyl group, 2-phenylethyl group, 1-phenylisopropyl group, 2-phenylisopropyl group, phenyl-t-butyl group, α -naphthylmethyl group, 1- α -naphthylethyl group, 2- α -naphthylethyl group, 1- α naphthylisopropyl group, 2- α -naphthylisopropyl group, β -naphthylmethyl group, 1- β -naphthylethyl group, 2- β -naphthylethyl group, 1- β -naphthylisopropyl group, 2- β -naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group and 1-chloro-2-phenylisopropyl group.

The cycloalkyl group of the aforementioned R₇ and Rsincludes, for examples, cyclopropyl group, cyclobutyl group, cyclopentyl group and cyclohexyl group.
The alkoxy group of the aforementioned R₇ and R₈ includes, for examples, methoxy group, ethoxy group, propoxy group, isopropoxy group, butoxy group, isobutoxy group, sec-butoxy group, tert-butoxy group, various types of pentyl group and various types of hexyloxy group.
The aryloxy group of the aforementioned R₇ and R₈ includes, for examples, phenoxy group, tolyloxy group, naphtyloxy group and the like.
The arylamino group of the aforementioned R₇ and R₈ includes, for examples, diphenylamino group, ditolylamino group, dinaphtylamino group and naphtylphenylamino group.
The alkylamino group of the aforementioned R₇ and R₈ includes, for examples, dimethylamino group, diethylamino group and dihexylamino group.

In the general formula (A2), each of e and f represents independently an integer of from 0 to 5 while e + f ≧ 1. Plural numbers of each of R₇ and R₈ may be the same with or different from each other respectively, and may form a saturated or unsaturated ring structure by linking each other, when each of e and f is 2 or more. The ring structure includes, for examples, a substituted or unsubstituted cycloalkyl group having 3 to 50 ring carbon atoms, a substituted or unsubstituted aromatic hydrocarbon group having 6 to 50 ring carbon atoms and a substituted or unsubstituted heterocyclic group having 5 to 50 ring atoms, and also may be condensed with a substituted or unsubstituted cycloalkyl group having 3 to 50 ring carbon atoms, a substituted or unsubstituted aromatic hydrocarbon group having 6 to 50 ring carbon atoms and a substituted or unsubstituted heterocyclic group having 5 to 50 ring atoms.
In the general formula (A2), each of Ar₁ to Ar₄ and s represents the similar to the aforementioned.

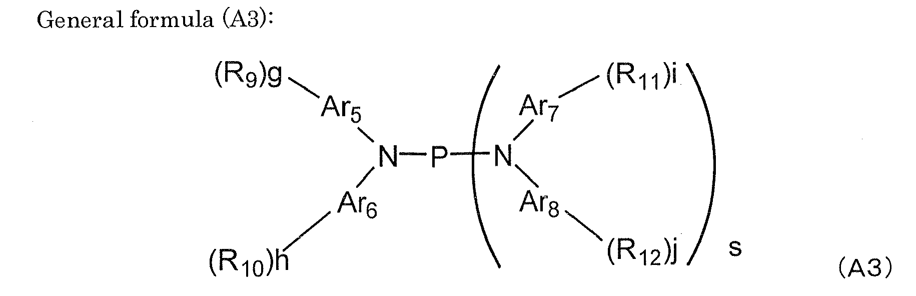

In the general formula (A3), P and s represent the same as the aforementioned. Each of R₉ to R₁₂ represents independently similar to those of the R₇ and R₈ and examples thereof include the similar ones to those of the R₇ and R₈.
In the general formula (A3), each of g to j represents an integer of from 0 to 5 while g + h + I + j ≧ 1. Plural numbers of each of R₉ to R₁₂ may be the same with or different from each other respectively when each of g to j is 2 or more, and may form a saturated or unsaturated ring structure by linking each other. Examples for a ring structure include the similar ones to those of the aforementioned.
In the general formula (A3), each of Ar₅ to Ar₈ represents independently a substituted or unsubstituted aromatic hydrocarbon group having 6 to 40 carbon atoms or a substituted or unsubstituted heterocyclic group having 3 to 40 carbon atoms. Examples for the aromatic hydrocarbon group and the heterocyclic group include the similar ones to those of the aforementioned Ar₁ to Ar₄ and bivalent moieties thereof.

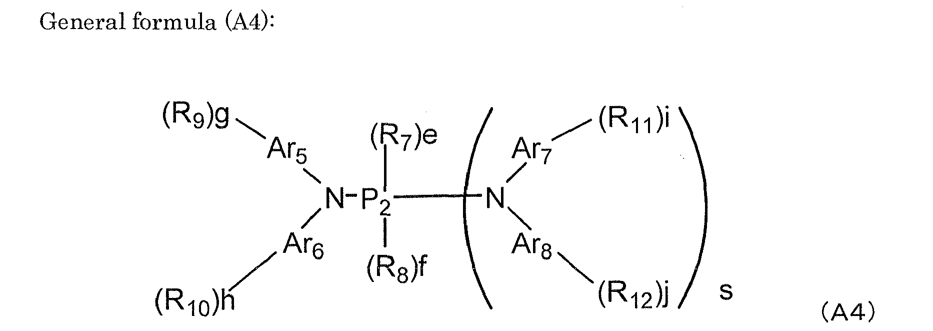

P₂, R₇, R₈, R₉ to R₁₂, Ar₅ to Ar₈, s and e to j are the same as the aforementioned.

In the aforementioned general formula (A3) and (A4), at least one of each of R₉ to R₁₂ represents preferably a substituted or unsubstituted secondary or tertiary alkyl group having 3 to 10 carbon atoms.
P in the aforementioned general formula (A) and (A3), P₁ in the aforementioned general formula (A1), and P₂ in the aforementioned general formula (A2) and (A4) represents preferably a moiety of naphthalene, phenanthrene, fluoranthene, anthracene, pyrene, perylene, chrysene, phenylanthracene or diphenylanthracene, or a moiety made by combining thereof.

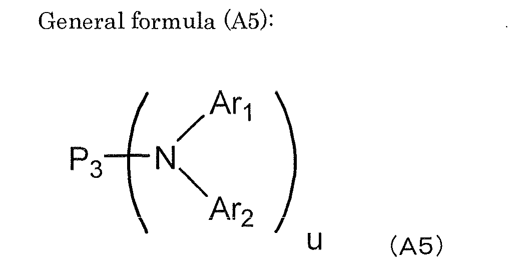

In the general formula (A5), each of Ar₁ to Ar₂ represents the same as the aforementioned and u represents an integer of from 1 to 4.
In the general formula (A5), P₃ represents a moiety of any compound represented by the general formula (7): 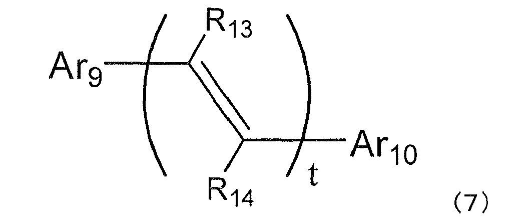 including a substituted or unsubstituted alkenyl structure having 10 to 40 carbon atoms.
In the general formula (7), each of Ar₉ to Ar₁₀ represents independently a substituted or unsubstituted aromatic hydrocarbon group having 6 to 40 carbon atoms or a substituted or unsubstituted heterocyclic group having 3 to 40 carbon atoms. Examples for the aromatic hydrocarbon group and the heterocyclic group of Ar₁₀ include respectively the similar ones to those of the aforementioned Ar₁ to Ar₄, and examples for the aromatic hydrocarbon group and the heterocyclic group of Ar₉ include trivalent moieties thereof.
In the general formula (7), each of R₁₃ to R₁₄ represents independently a hydrogen atom, a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms, and examples for each of the groups include the similar ones to those of the aforementioned in R₇ to R₈.
In the general formula (7), t represents an integer of from 1 to 4.

The amine compound represented by the aforementioned general formula (A) (including (A1) to (A5)) may be shown by the following examples, which should not be construed as limiting the amine compound. The symbol "Me" means a methyl group.

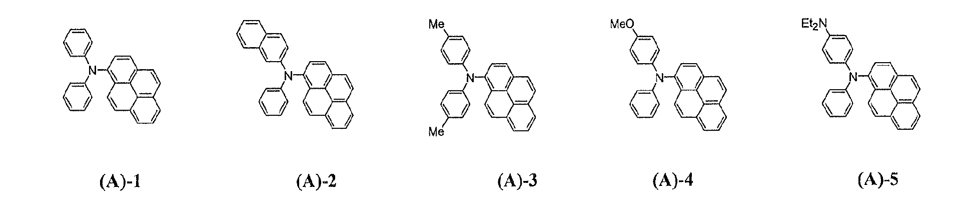

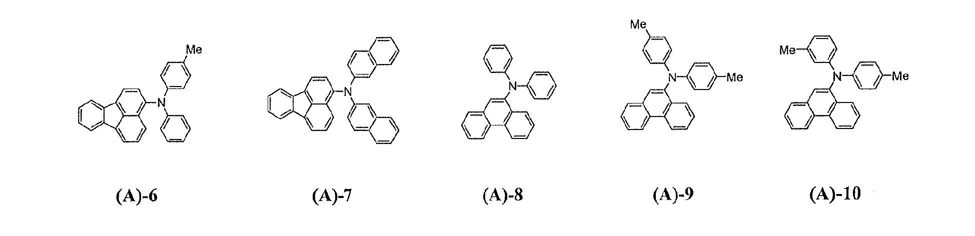

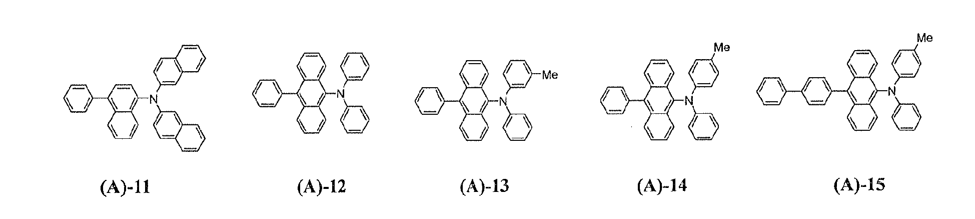

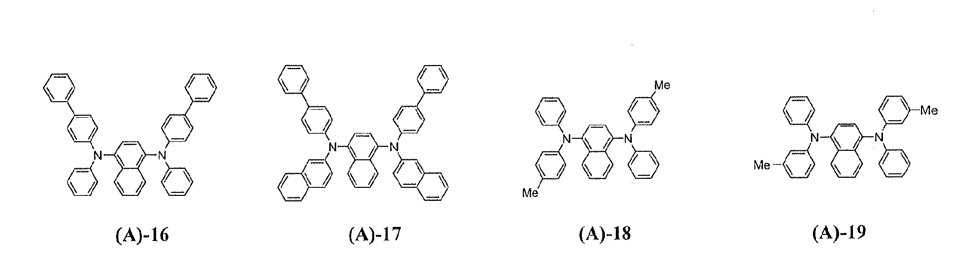

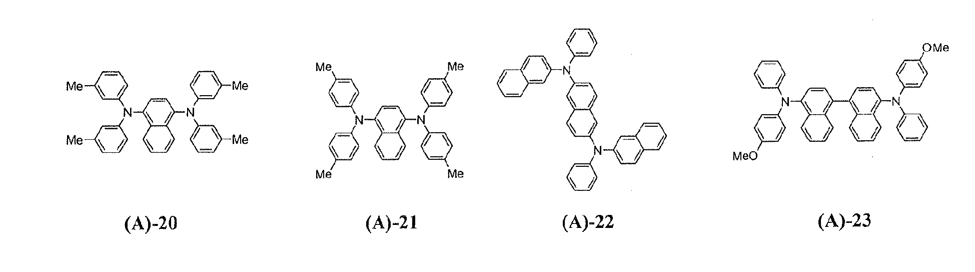

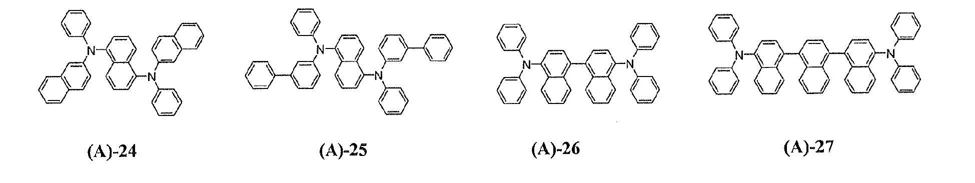

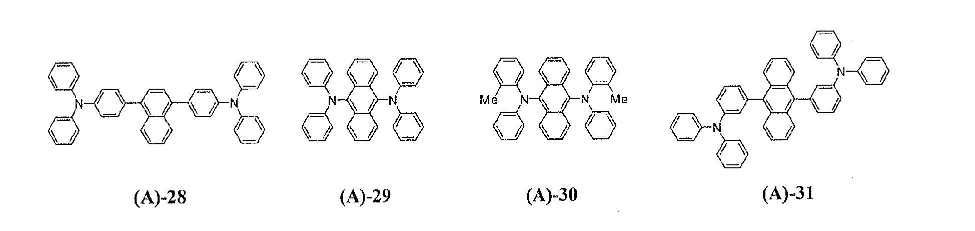

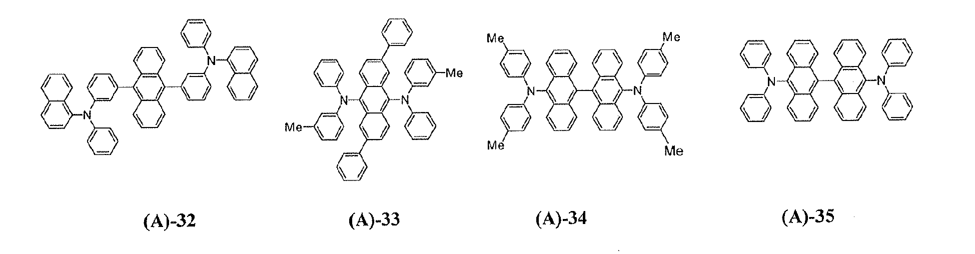

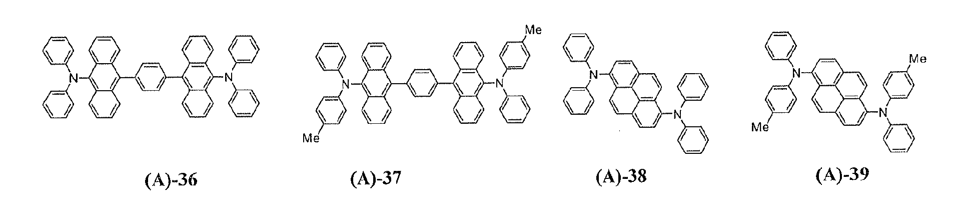

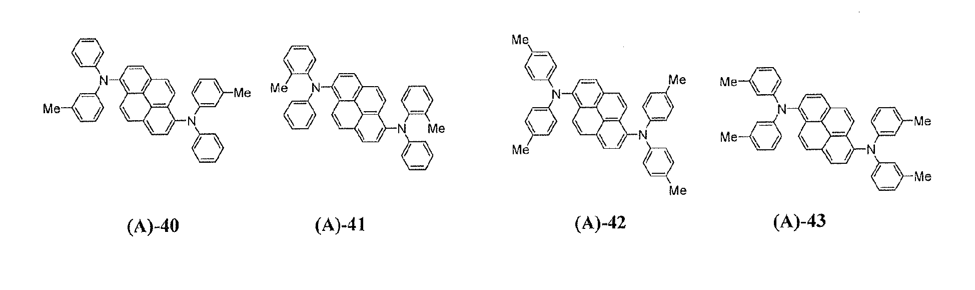

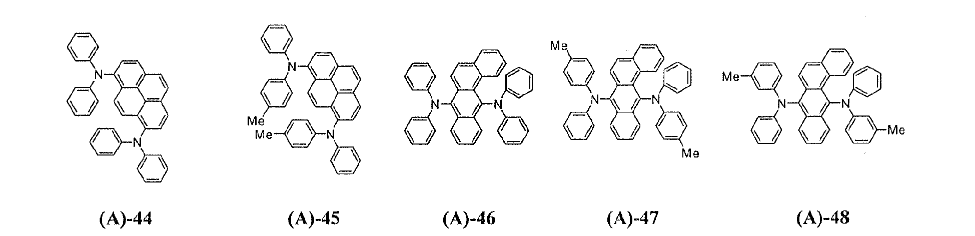

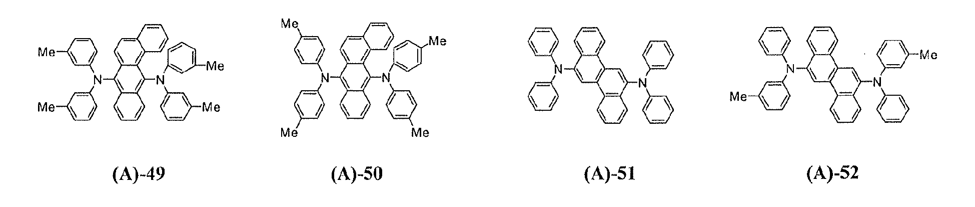

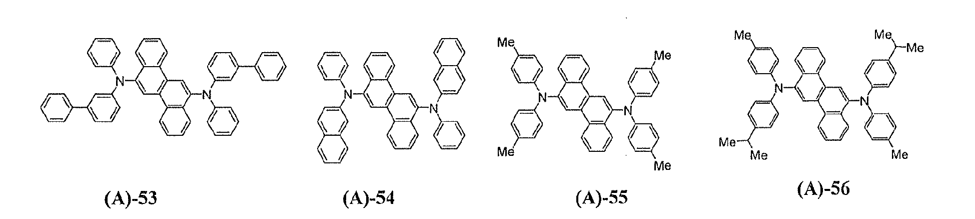

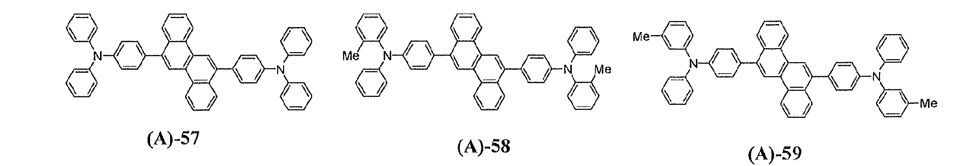

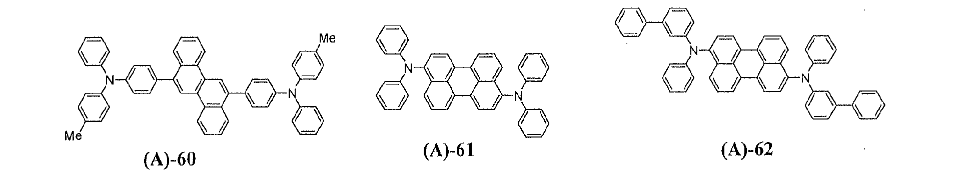

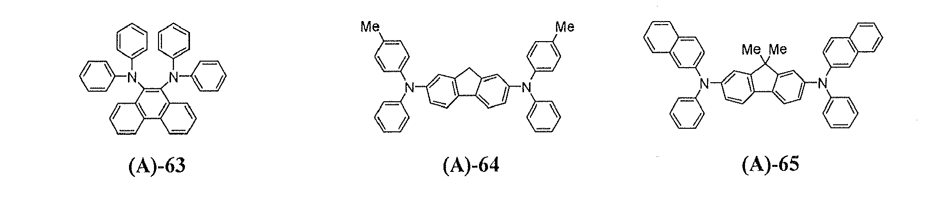

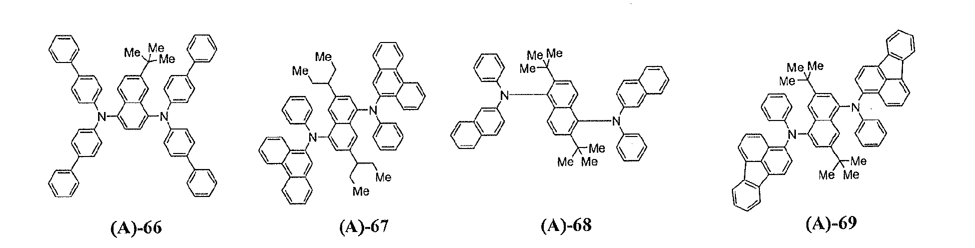

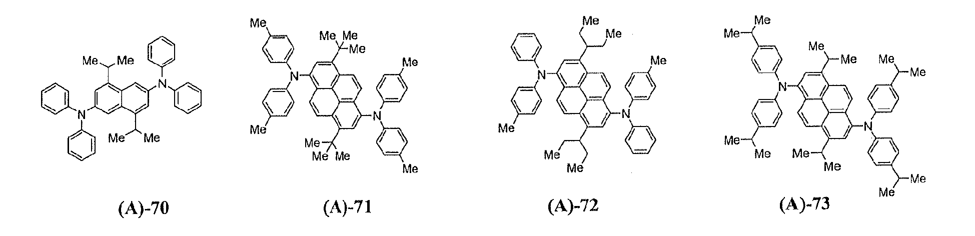

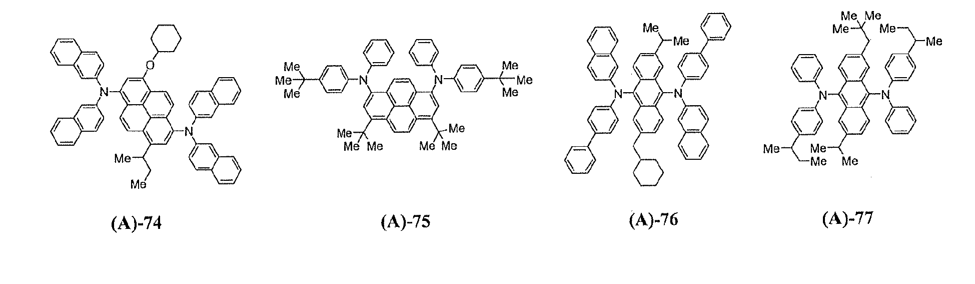

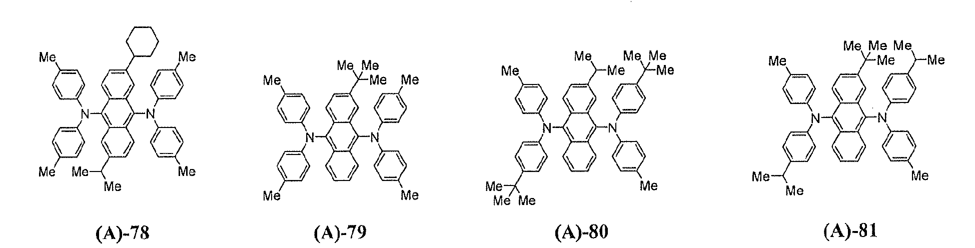

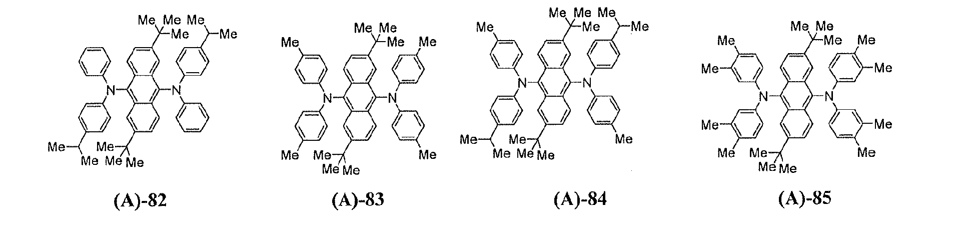

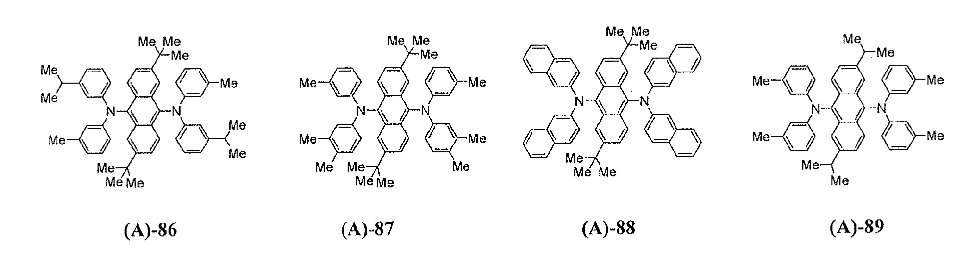

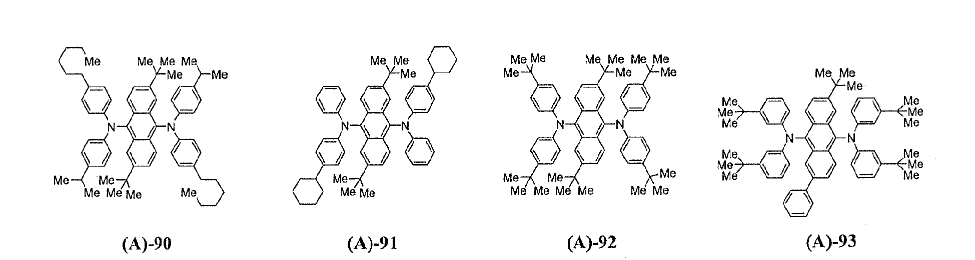

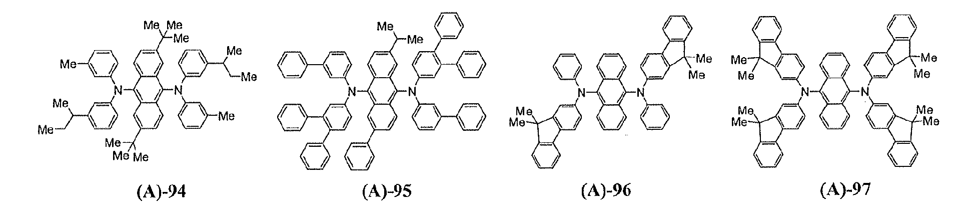

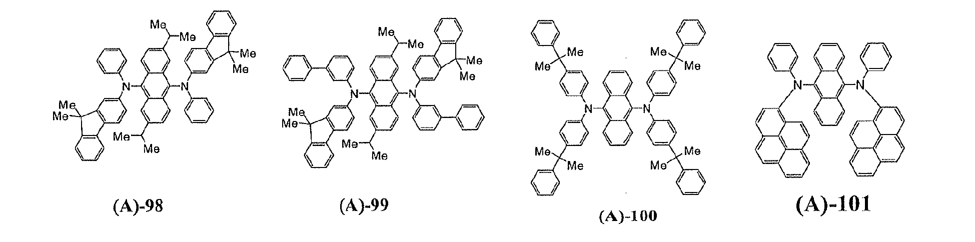

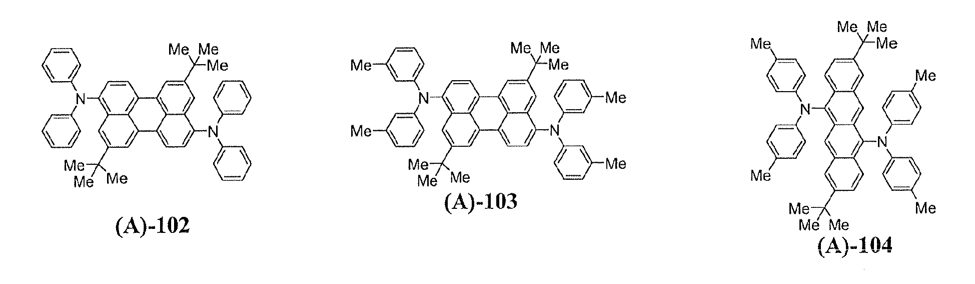

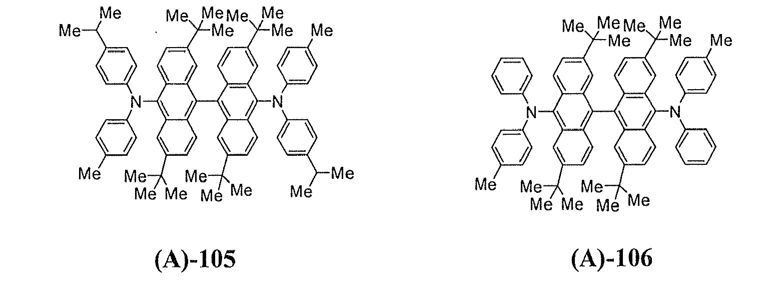

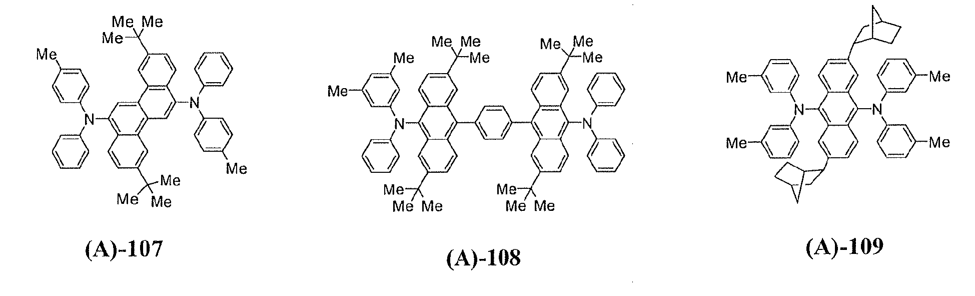

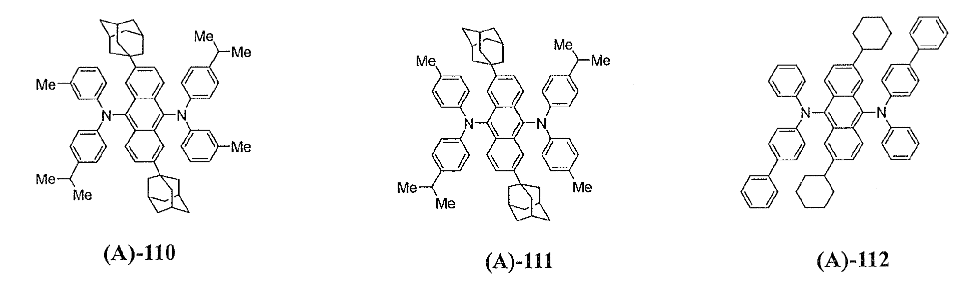

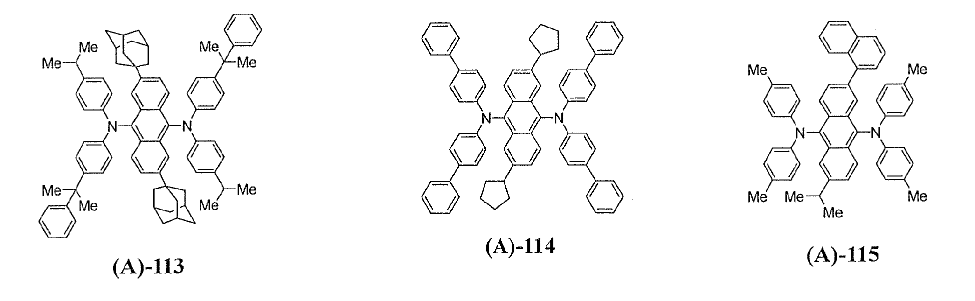

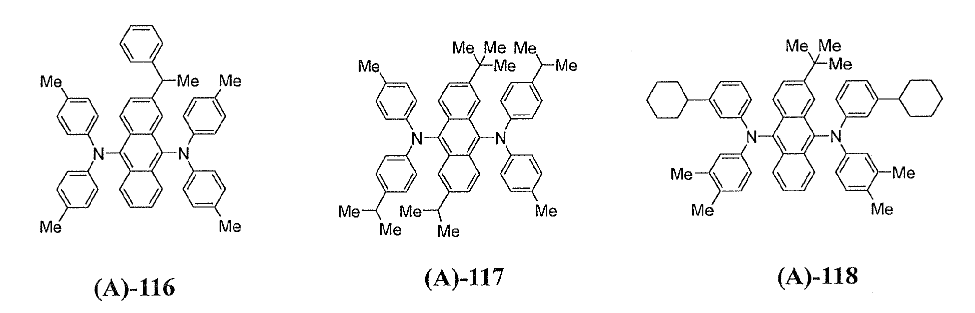

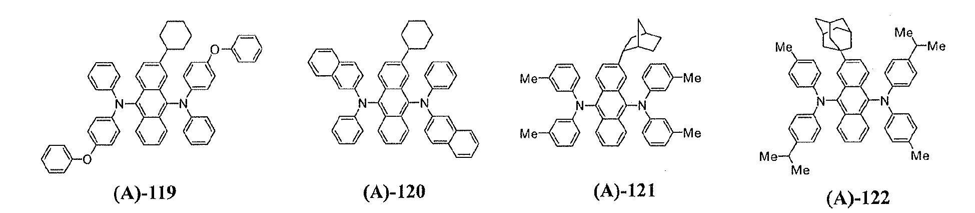

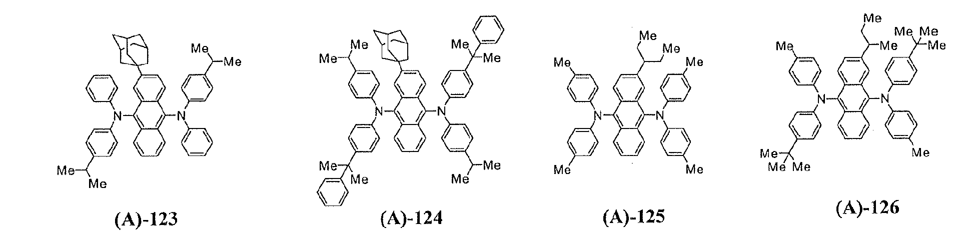

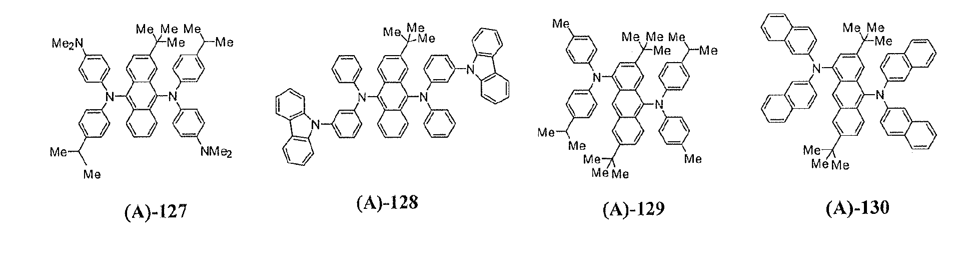

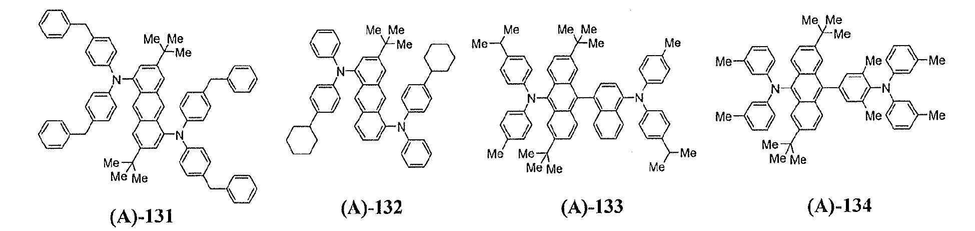

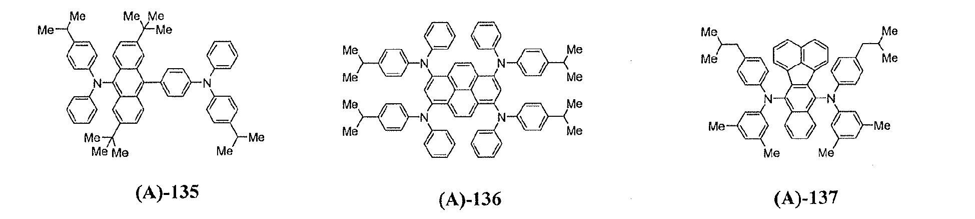

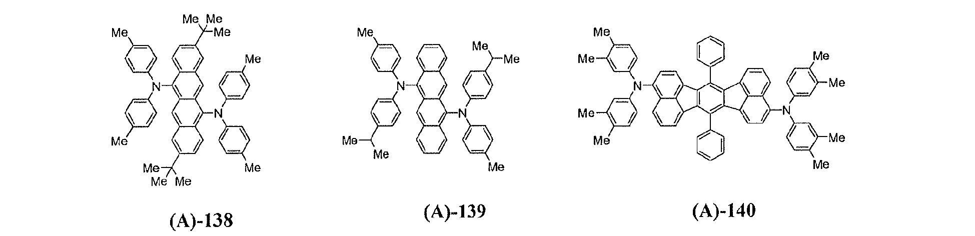

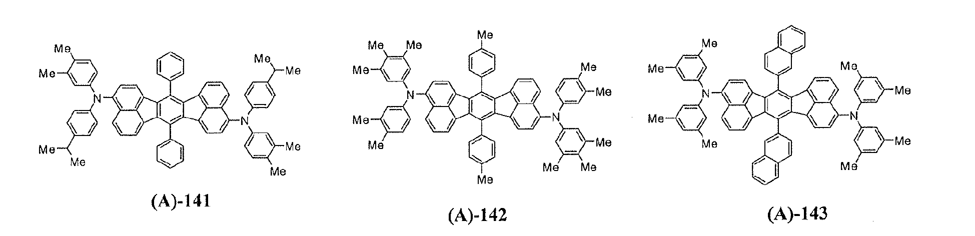

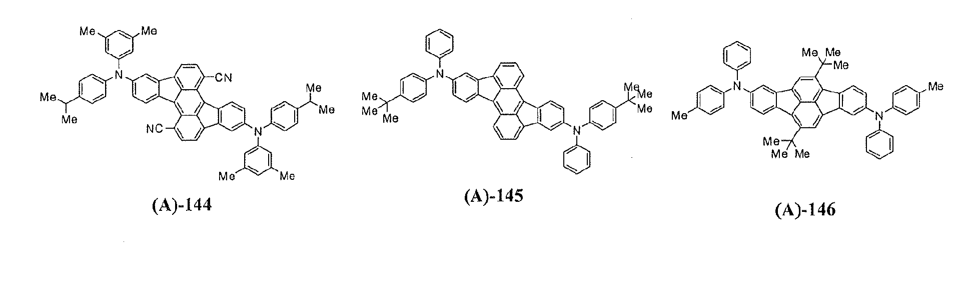

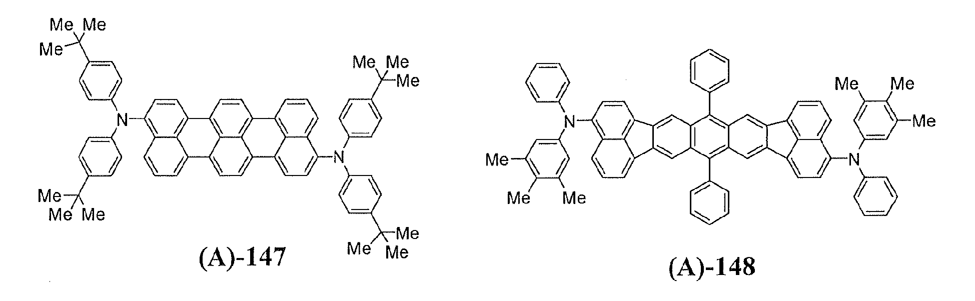

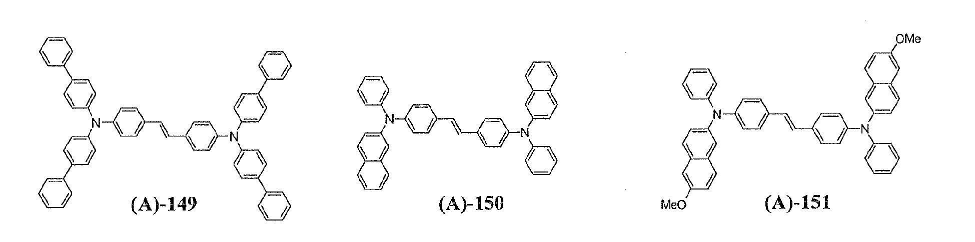

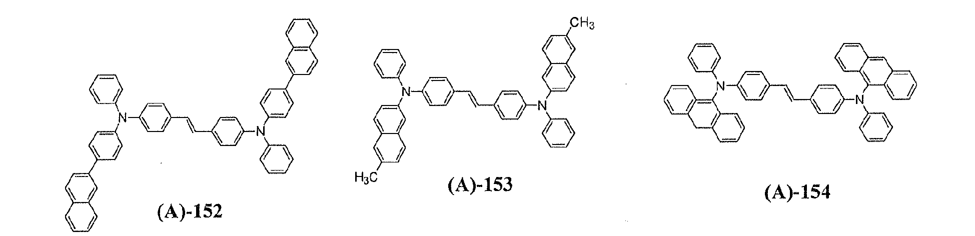

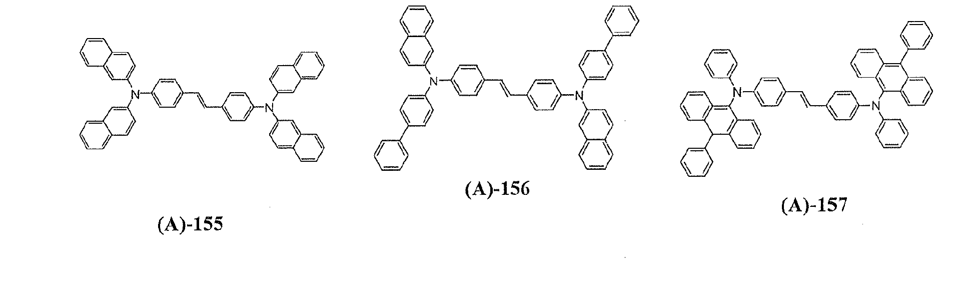

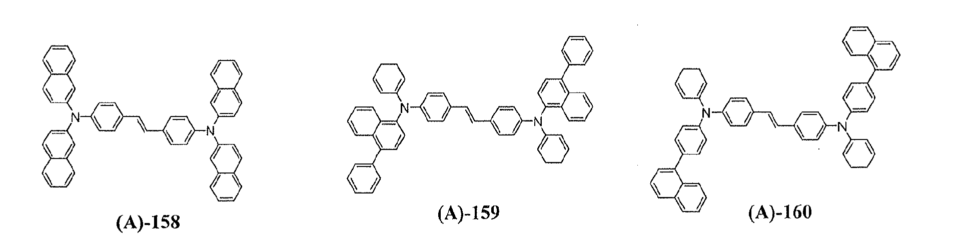

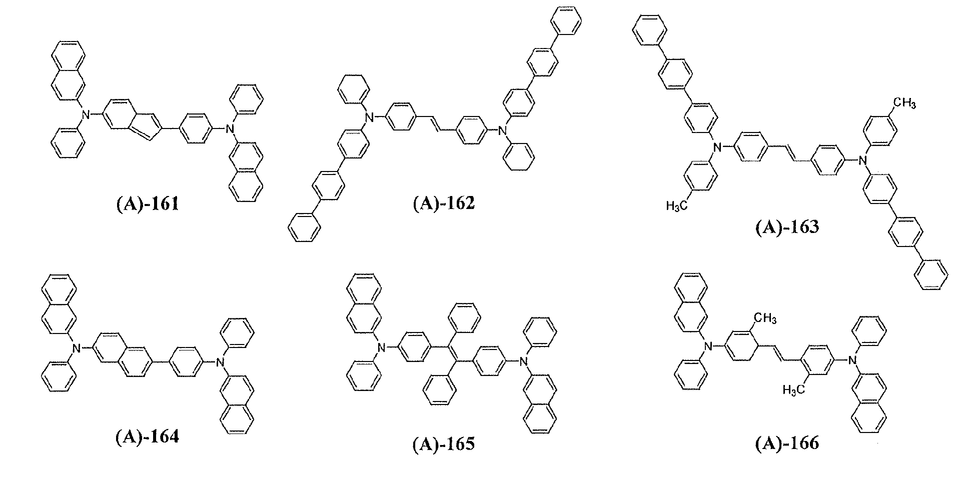

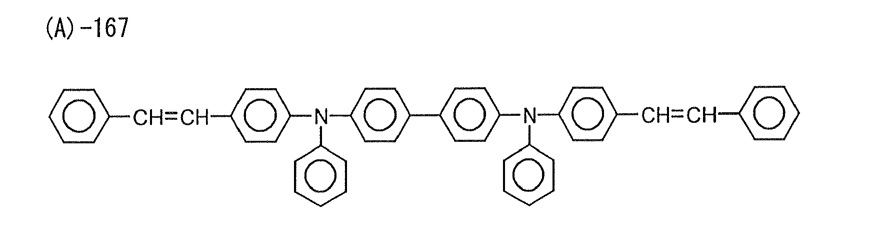

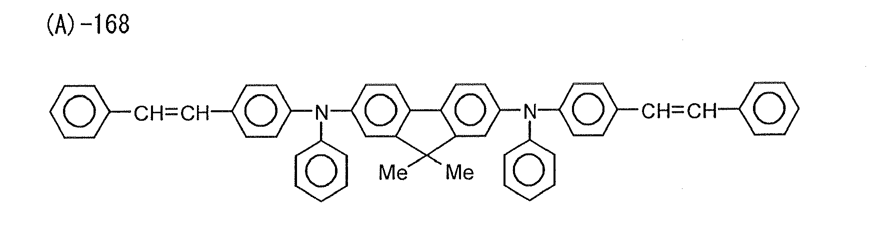

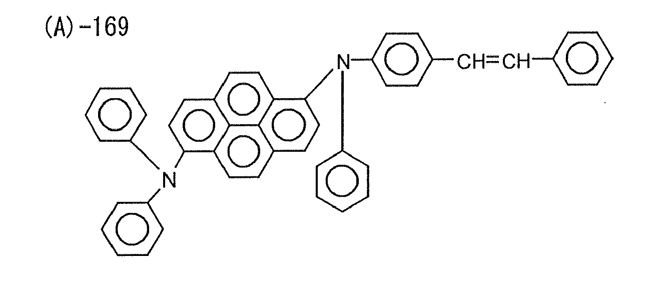

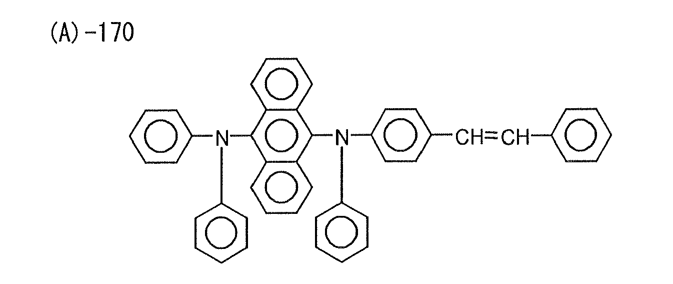

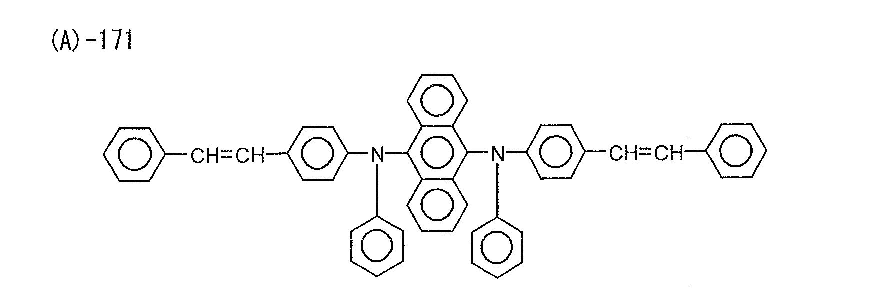

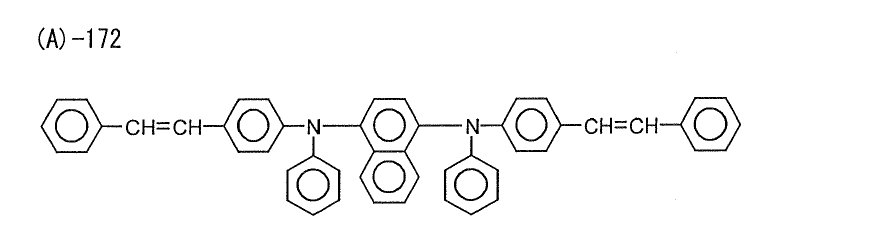

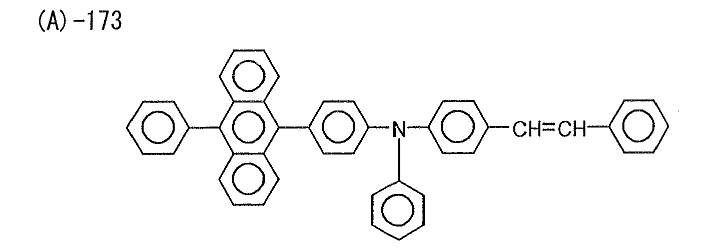

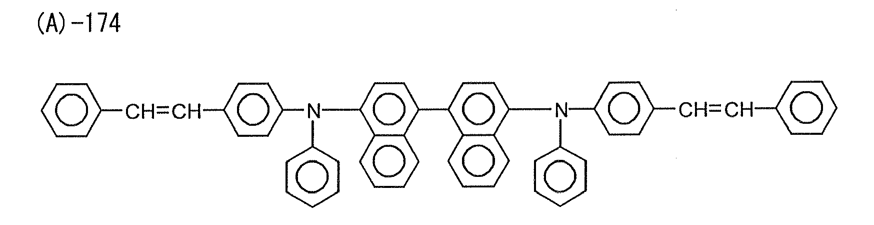

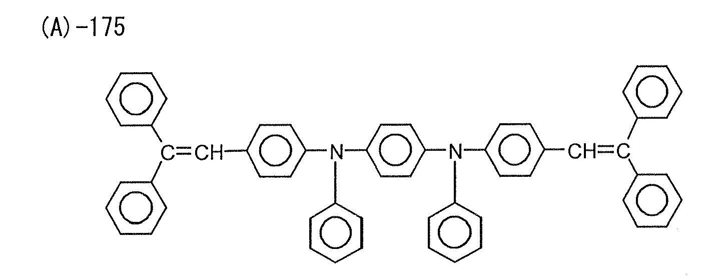

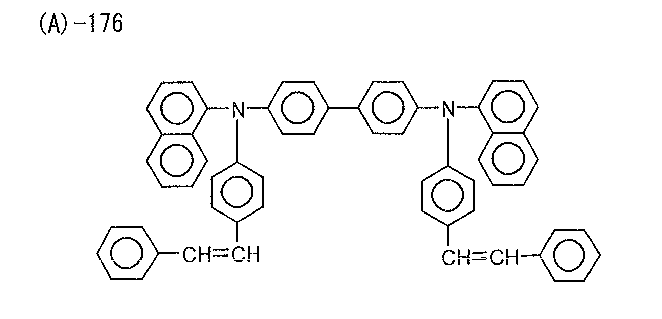

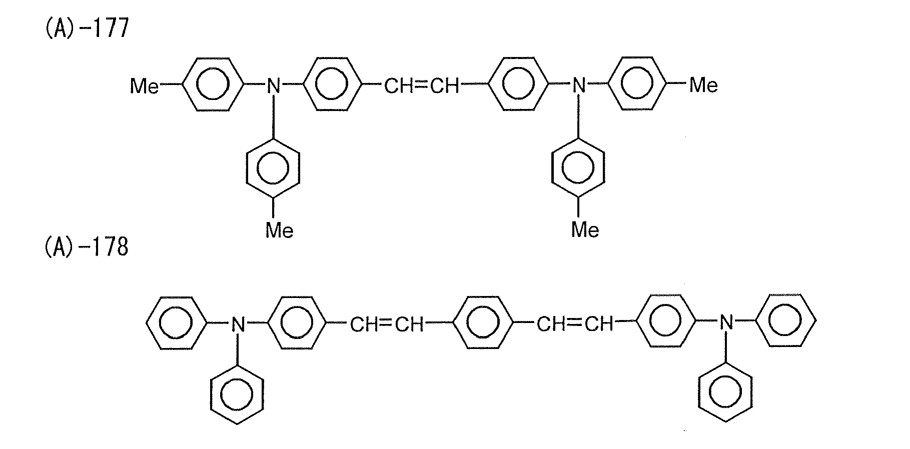

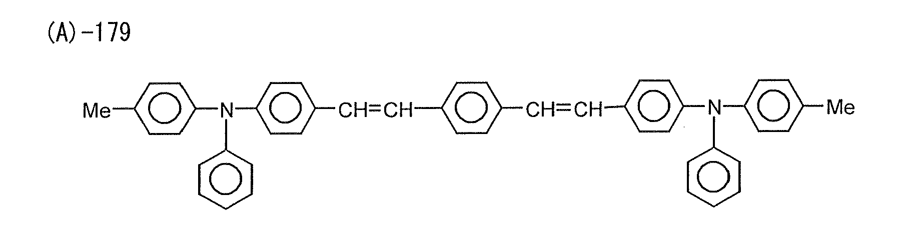

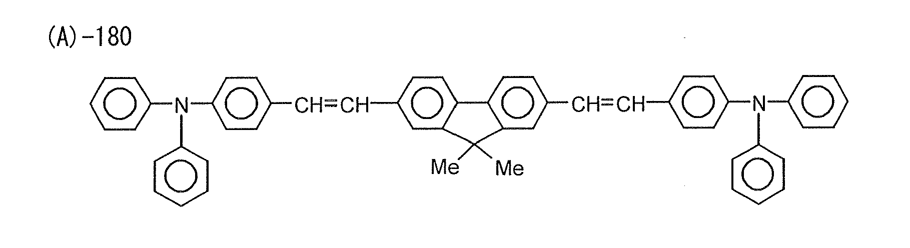

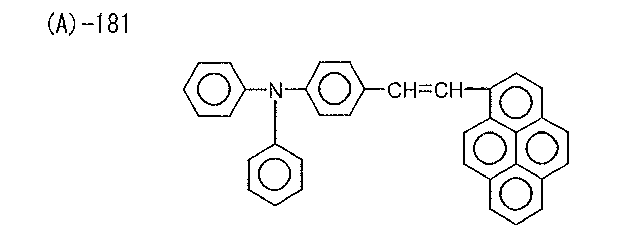

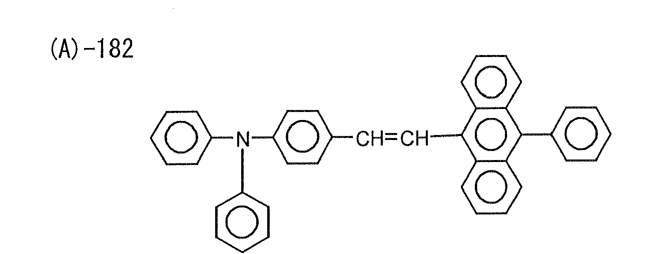

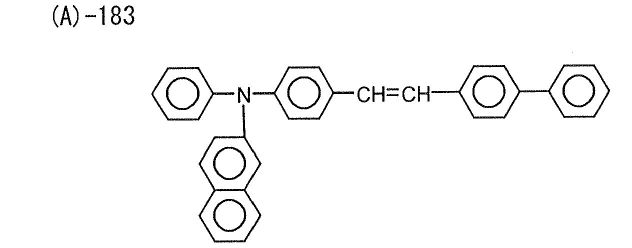

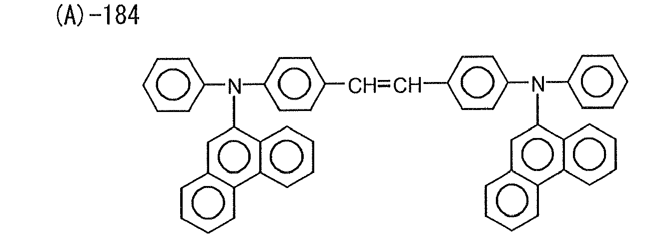

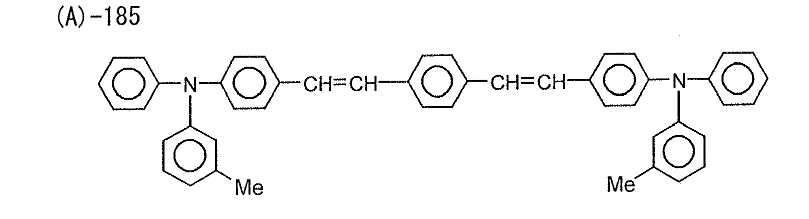

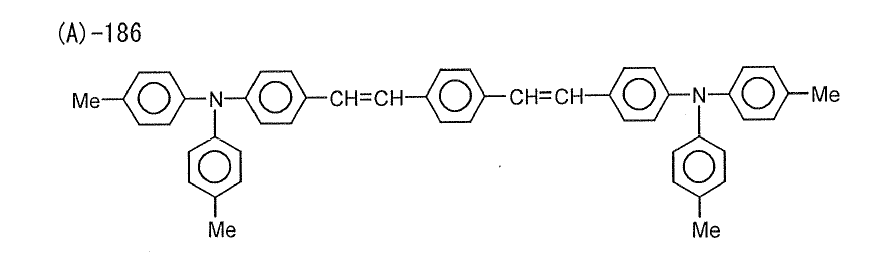

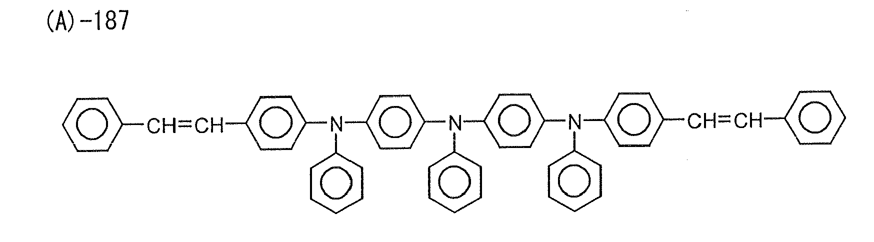

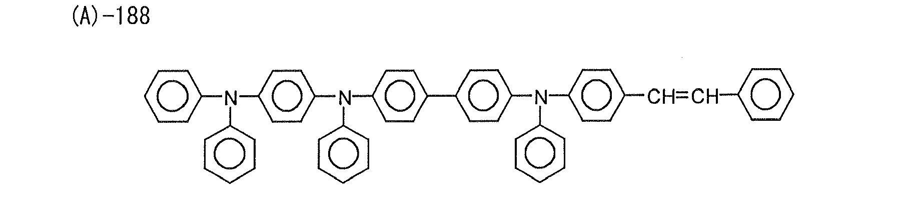

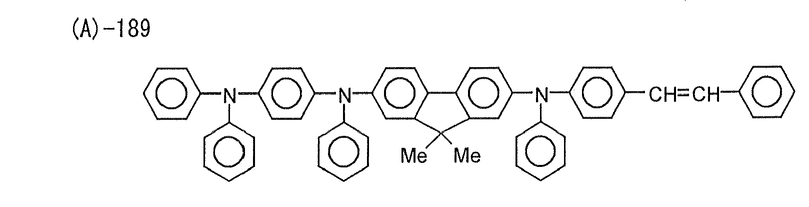

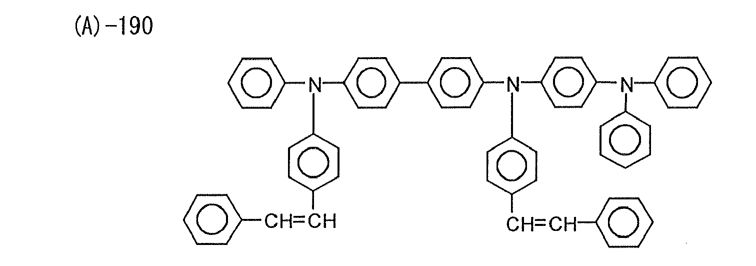

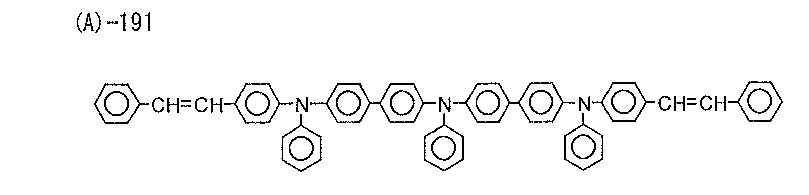

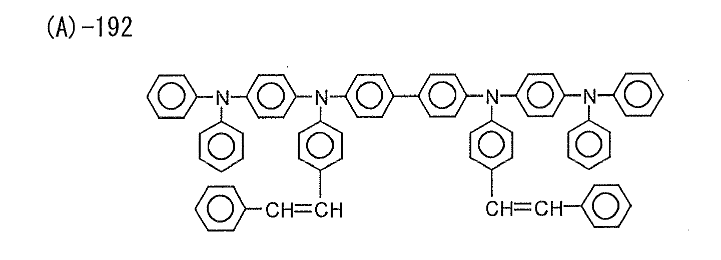

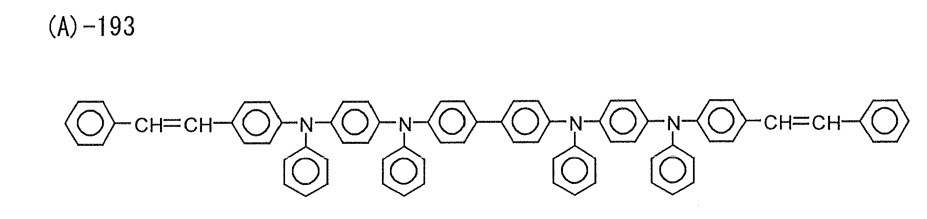

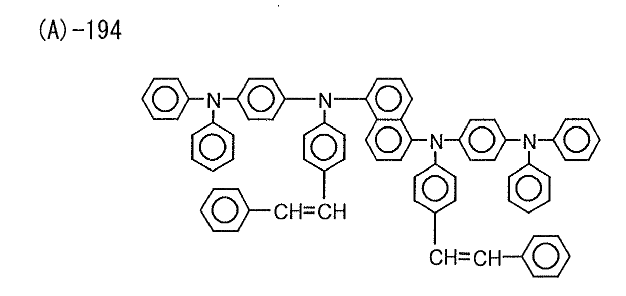

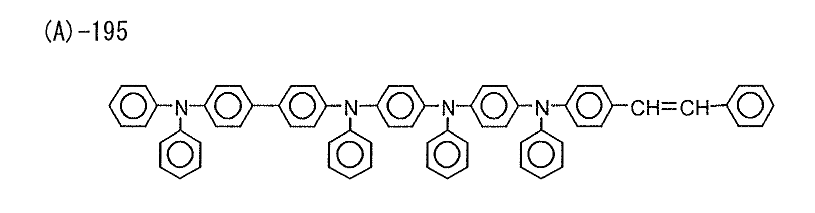

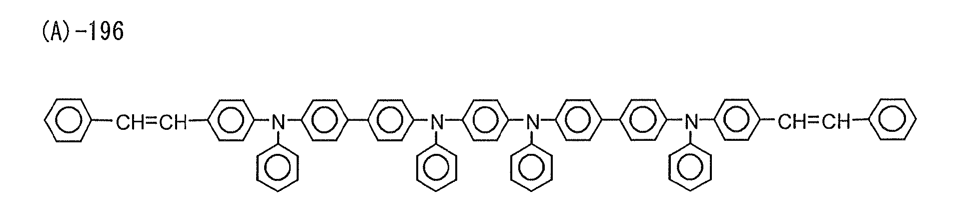

Next, fluorene-based compounds are explained as follows;

(A-X)ₘ - (FL-B)ₙ (B)

In the general formula (B), m is an integer of from 0 to 10, preferably from 0 to 4 and more preferably from 1 to 2.
In the general formula (B), n is an integer of from 1 to 10, preferably from 1 to 5 and more preferably from 1 to 3.
In the general formula (B), A represents a substituted or unsubstituted aromatic hydrocarbon group having 6 to 50 ring carbon atoms, a substituted or unsubstituted heterocyclic group having 6 to 50 ring atoms, a substituted or unsubstituted alkyl group having 1 to 50 carbon atoms, or a substituted or unsubstituted alkenyl group having 1 to 50 carbon atoms, and plural numbers of A may be the same with or different from each other when m is 2 or more.
In the general formula (B), B represents a single bond, a hydrogen atom, a substituted or unsubstituted aromatic hydrocarbon group having 6 to 50 ring carbon atoms, a substituted or unsubstituted alkyl group or alkylene group having 1 to 50 carbon atoms, a substituted or unsubstituted alkenyl group or alkenylene group having ring 1 to 50 carbon atoms, and plural numbers of B may be the same with or different from each other when n is 2 or more.

The aromatic hydrocarbon group in the aforementioned A and B includes a phenyl group, 1-naphtyl group, 2-naphtyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthaceryl group, 2-naphthacery group, 9-naohthacery group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group and the like, and any of bivalent group thereof.

Examples of the heterocyclic group in the aforementioned A include 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-iso indolyl group,2-iso indolyl group, 3-iso indolyl group, 4-iso indolyl group, 5- iso indolyl group, 6-iso indolyl group, 7-iso indolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthrohne-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrole-1-yl group, 2-methylpyrrole-3-yl group, 2-methylpyrrole-4-yl group, 2-methylpyrrole-5-yl group, 3-methylpyrrole-1-yl group, 3-methylpyrrole-2-yl group, 3-methylpyrrole-4-yl group, 3-methylpyrrole-5-yl group, 2-t-butylpyrrole-4-yl group, 3-(2-phenylpropyl) pyrrole-1-yl group, 2-methyl-1-indolyl group, 4-methyl-1-indolyl group, 2-methyl-3-indolyl group, 4-methyl-3-indolyl group, 2-t-butyl 1-indolyl group, 4-t-butyl 1-indolyl group, 2-t-butyl 3-indolyl group, 4-t-butyl 3-indolyl group, etc., and any of bivalent group thereof.

Examples of the alkyl group in the aforementioned A and B include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 1,2,3-triiodopropyl group, cyclopropyl group, cyclobutyl group, cyclopenthyl group, cyclohexyl group, 4-methylcyclohexyl group, adamantan-1,1-diyl group, adamantan-1,3-diyl group, etc. In addition, the alkylene group therein includes any of bivalent group thereof.

Examples of the alkenyl group in the aforementioned A and B include vinyl group, allyl group, 1-butenyl group, 2-butenyl group, 1,3-butadienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group, 3-phenyl-l-butenyl group and the like. In addition, the alkylene group includes any of bivalent group thereof.

In the general formula (B), X represents a single bond, a substituted or unsubstituted aromatic hydrocarbon group having 6 to 50 ring carbon atoms, a substituted or unsubstituted alkylene group having 1 to 50 carbon atoms, a substituted or unsubstituted alkenylene group having 1 to 50 carbon atoms, and plural numbers of X may be the same with or different from each other when m is 2 or more.
Each of an aromatic hydrocarbon group, an alkylene group and alkenylene group of the aforementioned X includes the similar groups to those of the aforementioned A and B.
In the general formula (B), FL represents a group comprising a fluorene-based derivative group or a combination thereof represented by any of the following general formulae (1) to (6) and plural numbers of FL may be the same with or different from each other when n is 2 or more.

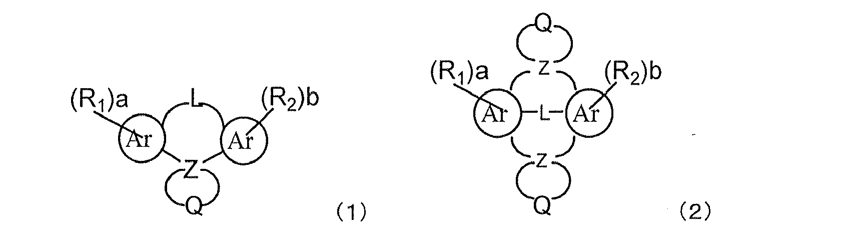

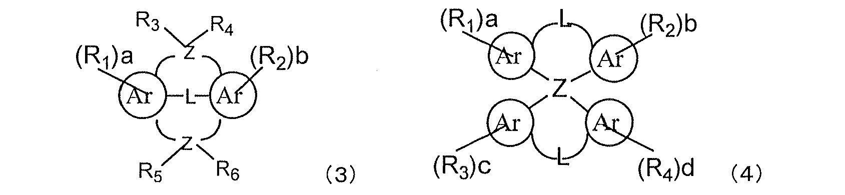

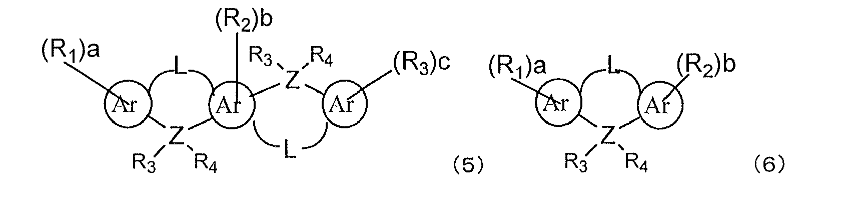

In the general formulae (1) to (6), L represents a single bond, -(CR'R")ₖ-, -(SiR'R")ₖ-, -O-, -CO- or -NR'-.
Each of R' and R" represents independently a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 2 to 50 carbon atoms, a carboxyl group, a halogen atom, a cyano group, a nitro group or a hydroxyl group, and the members thereof may link each other to form a ring structure; k represents an integer of from 1 to 10 and each of R' and R" may be the same with or different from each other.

Examples of the aromatic hydrocarbon group, the heterocyclic group or the alkyl group of the aforementioned R' and R" include the similar groups to those of the aforementioned A and B.
The alkoxy group of the aforementioned R' and R" means a group represented by - OY₁, and examples for Y₁ include the similar groups to the aforementioned alkyl groups.
Examples of the aforementioned aralkyl group in the aforementioned R' and R" include benzyl group, 1-phenylethyl group, 2-phenylethyl group, 1-phenylisopropyl group, 2-phenylisopropyl group, phenyl-t-butyl group, α -naphthylmethyl group, 1- α-naphthylethyl group, 2-α -naphthylethyl group, 1- α naphthylisopropyl group, 2- α -naphthylisopropyl group, β -naphthylmethyl group, 1- β -naphthylethyl group, 2- β -naphthylethyl group, 1- β -naphthylisopropyl group, 2- β -naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group and 1-chloro-2-phenylisopropyl group, etc. The aryloxy group of the aforementioned R' and R" means a group represented by - OY₂, and examples for Y₂ include the similar groups to the aforementioned aromatic hydrocarbon groups.
The arylthio group of the aforementioned R' and R" means a group represented by - SY₃, and examples for Y₃ include the similar groups to the aforementioned aromatic hydrocarbon groups.
The alkoxycarbonyl group of the aforementioned R' and R" means a group represented by -COOZ₁, and examples for Zi include the similar groups to the aforementioned alkyl groups.
Examples for the halogen atom of the aforementioned R' and R" include a fluorine atom, a chlorine atom and a bromine atom.

In the general formulae (1) to (6), Z represents a carbon atom, a silicon atom or a germanium atom.
In the general formulae (1) to (6), Q represents a group being capable of forming a ring structure and examples of the ring structure comprised by Z-Q include a substituted or unsubstituted cycloalkyl group having 3 to 50 ring carbon atoms, a substituted or unsubstituted aromatic hydrocarbon group having 6 to 50 ring carbon atoms, or a substituted or unsubstituted heterocyclic group having 5 to 50 ring atoms, and also the ring structure may include a condensed one with a substituted or unsubstituted cycloalkyl group having 3 to 50 ring carbon atoms, a substituted or unsubstituted aromatic hydrocarbon group having 6 to 50 ring carbon atoms or a substituted or unsubstituted heterocyclic group having 5 to 50 ring atoms.
Examples of the cycloalkyl group of the aforementioned Q include a cyclopropyl group, cyclobutyl group, cyclopentyl group and cyclohexyl group.
In addition, examples for the aromatic hydrocarbon group and the heterocyclic group of the aforementioned Q include respectively the similar ones to those of the A and B.

In the general formulae (1) to (6), Ar expresses a ring structure shown by a circle enclosing a symbol Ar, and represents a moiety of cycloalkane having 3 to 20 ring carbon atoms which may have a substituent, an aromatic hydrocarbon group having 6 to 50 ring carbon atoms which may have a substituent, or a heterocyclic group having 5 to 50 ring atoms which may have a substituent, and plural numbers of Ar, if any, may be the same with or different from each other.
Examples of the aromatic hydrocarbon group and the heterocyclic group of the aforementioned Ar include the moiety of examples respectively represented by the aforementioned A and B. Examples of the moiety of cycloalkane having 3 to 20 ring carbon atoms, whose carbon atom may be replaced by a nitrogen atom include a moiety of cyclopropane, cyclobutane, cyclohexane, cycloheptane, pyrrolidine, piperidine and piperazine.

In the general formulae (1) to (6), each of R₁ to R₆ represents independently a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group or a hydroxyl group. Plural numbers of R₁ to R₆, if any, may be the same with or different from each other, and the adjoining ones among R₁ to R₆ may link each other to form a ring structure.
Examples of each group represented by the aforementioned R₁ to R₆ include the similar groups to those of the aforementioned R' and R". In addition, examples of the ring structure include the similar ones to the ring structures comprised by Z-Q.
In the general formulae (1) to (6), each of a to d is an integer of from 0 to 4.

The following is preferable examples of the general formulae (1) to (6):

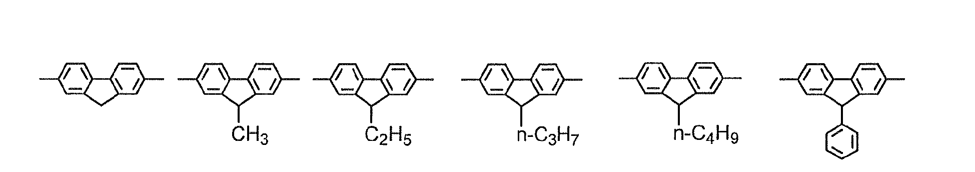

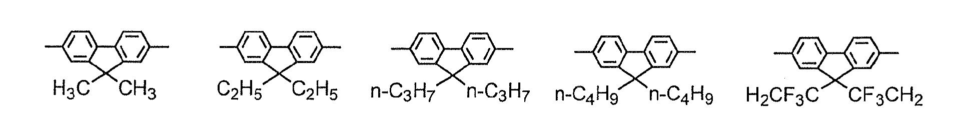

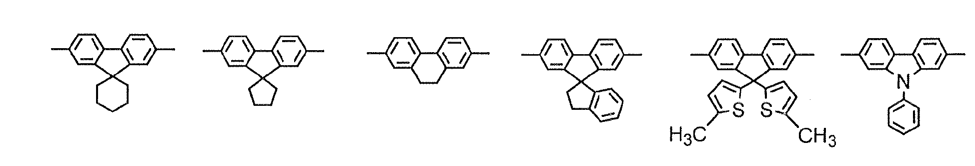

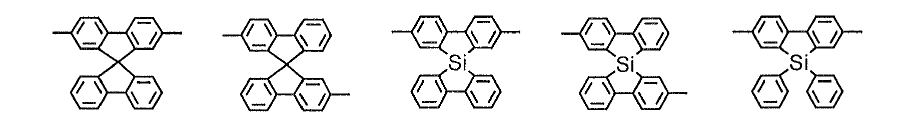

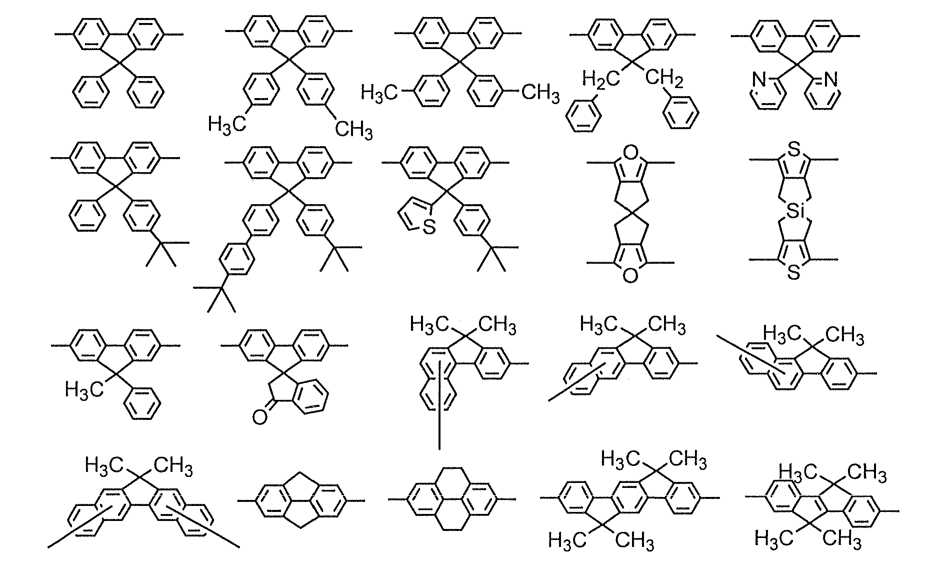

In the organic EL devices of the present invention, it is preferable that the amine compound represented by the general formula (A) is any of the amine compounds represented by the aforementioned general formula (A1), and the aforementioned FL in the fluorene-based compound represented by the general formula (B) is any of the fluorene-based derivative groups represented by any of the general formulae (1) to (5) or any of the groups made by combining thereof.
In addition, the following is preferable for the fluorene-based compounds represented by the general formula (B).

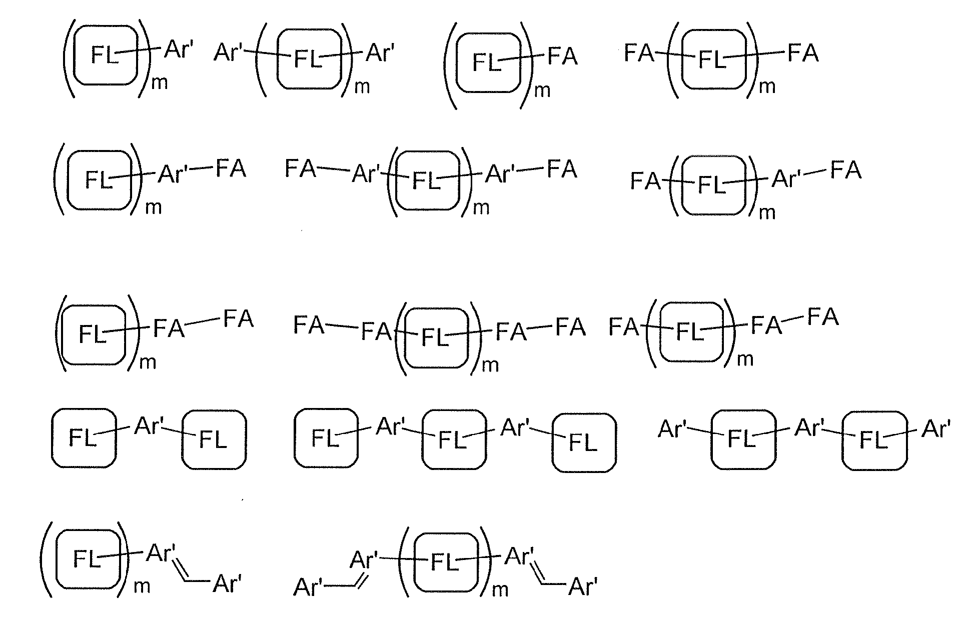

In each of the aforementioned general formulae, FL represents a fluorene-based derivative group represented by any of the general formulae (1) to (6). Ar' represents a moiety of a substituted or unsubstituted cycloalkane having 3 to 50 ring carbon atoms, a substituted or unsubstituted aromatic hydrocarbon group having 6 to 50 ring carbon atoms, or a substituted or unsubstituted heterocyclic group having 5 to 50 ring atoms; and FA represents a substituted or unsubstituted condensed-aromatic hydrocarbon group having 8 to 50 ring carbon atoms or a substituted or unsubstituted condensed-heterocyclic group having 8 to 50 ring atoms.
Specific examples for each of the groups of Ar' and FA includes respectively the similar groups to those of the aforementioned Ar, and the preferable moieties of condensed-ring group include the following structures:

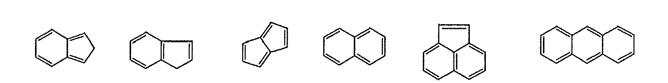

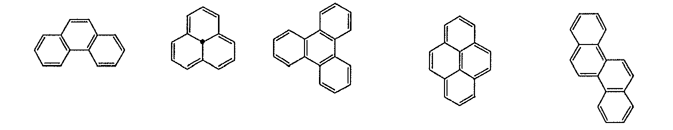

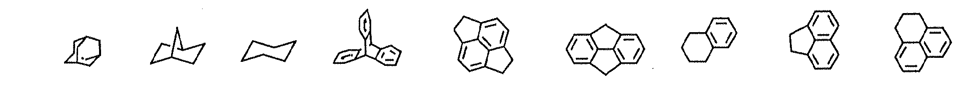

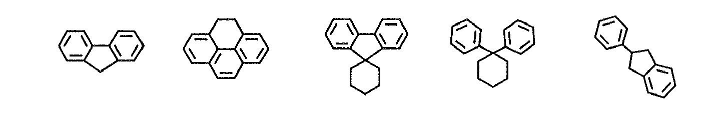

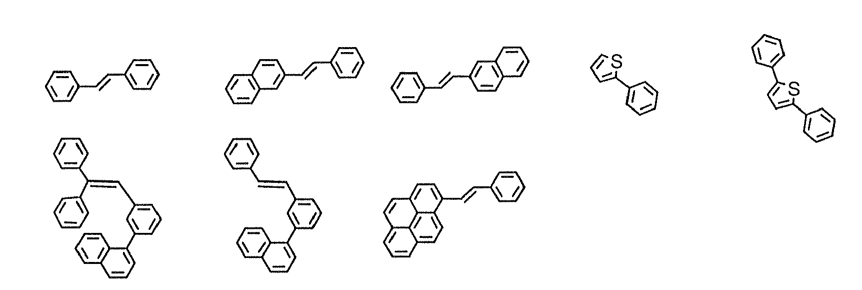

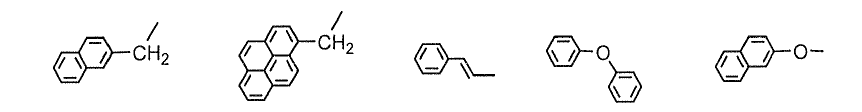

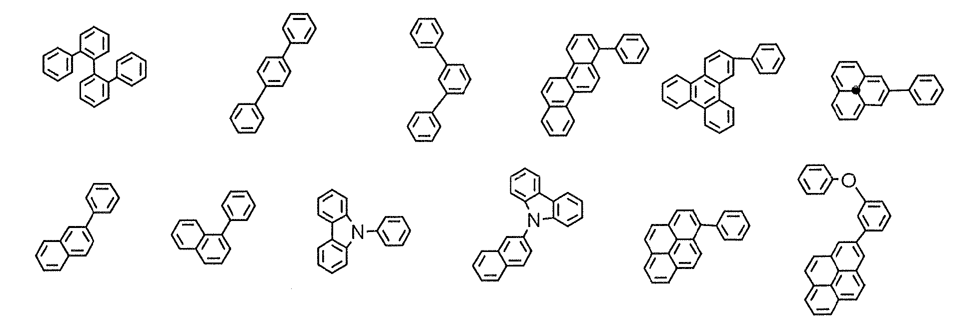

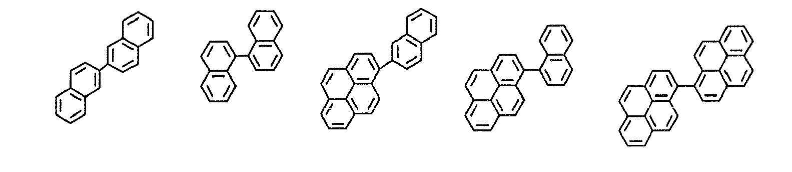

The fluorene-based compound represented by the general formula (B) may be shown by the following examples, which should not be construed as limiting the compound.

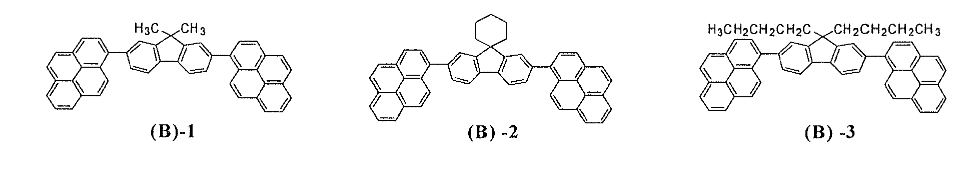

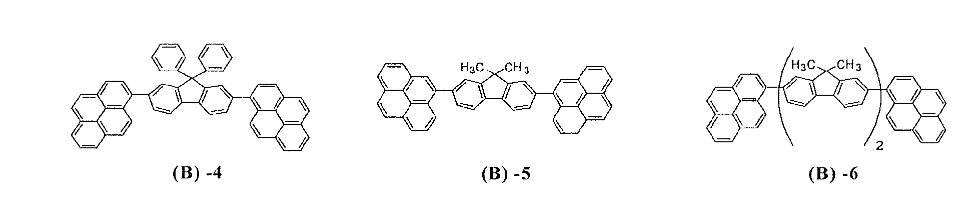

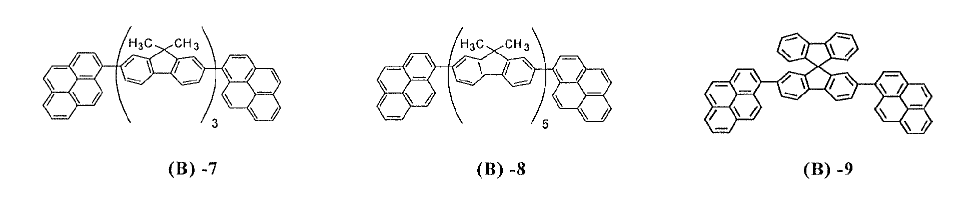

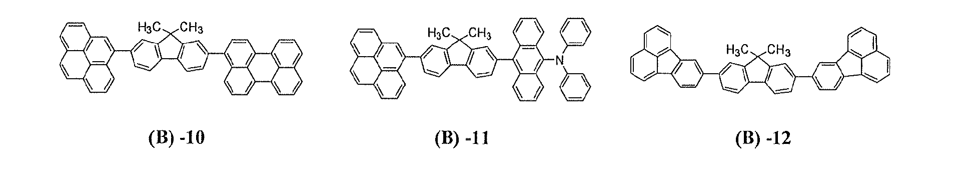

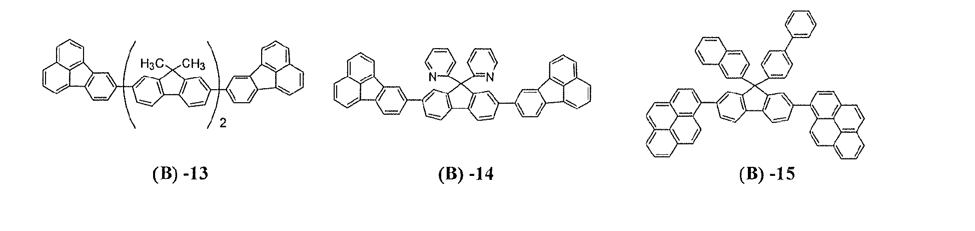

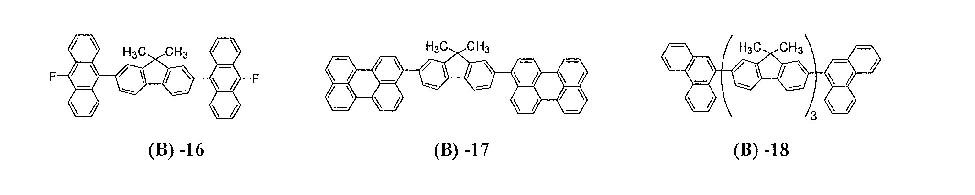

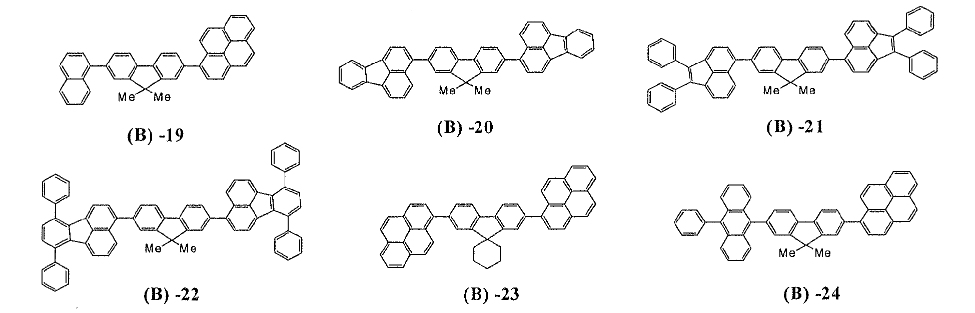

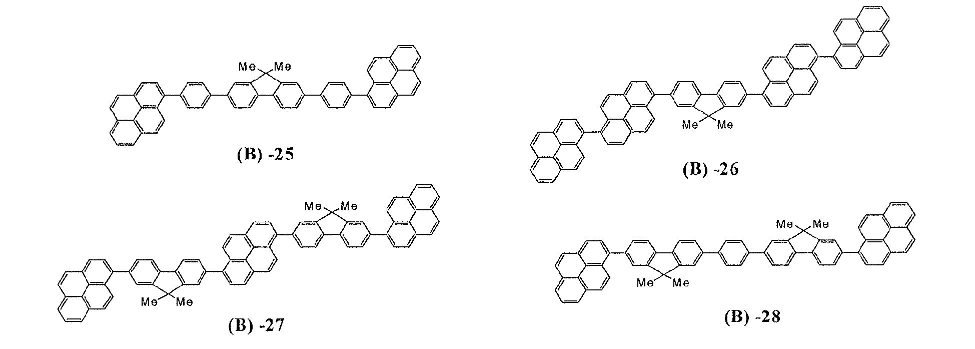

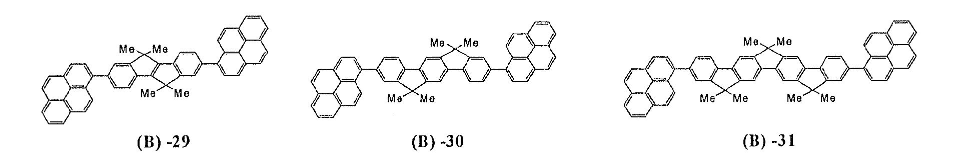

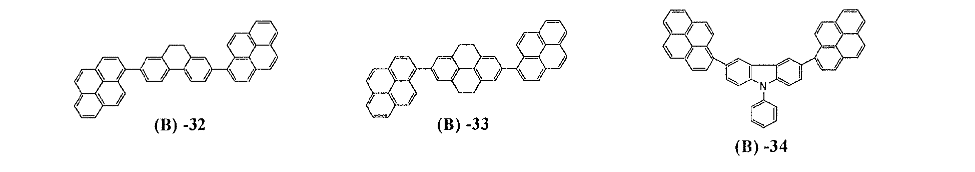

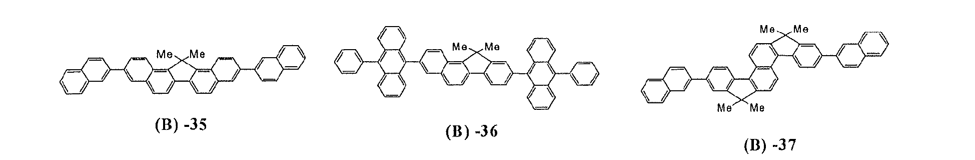

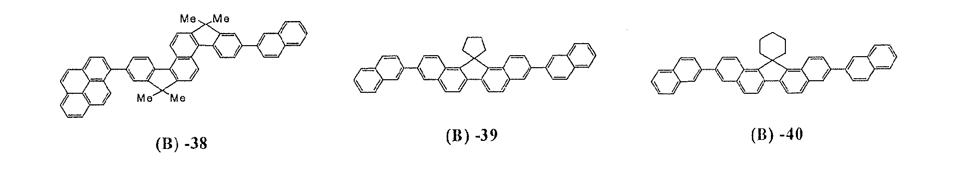

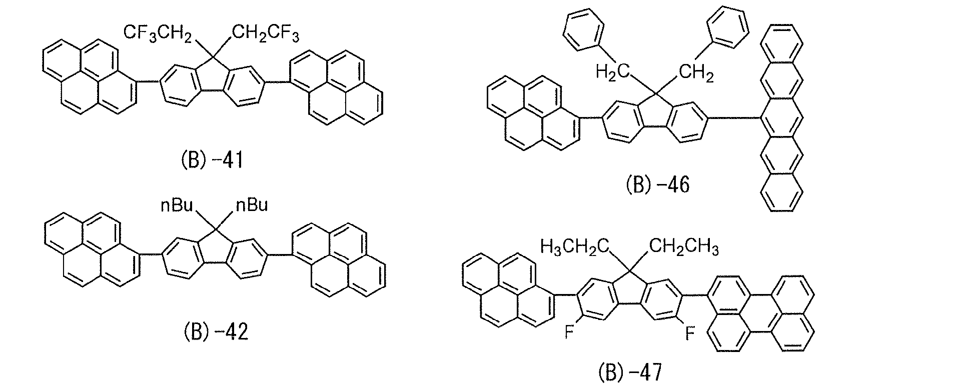

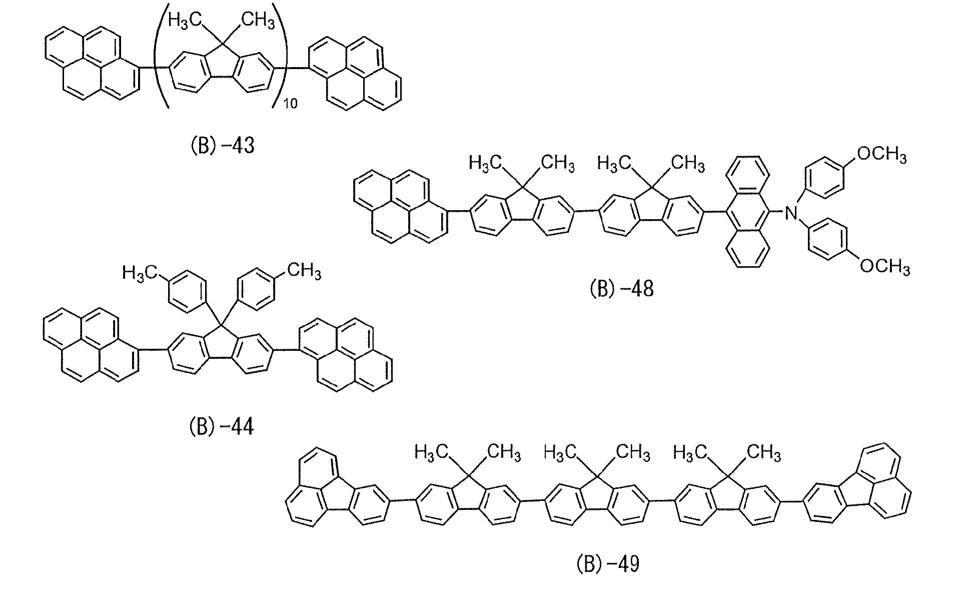

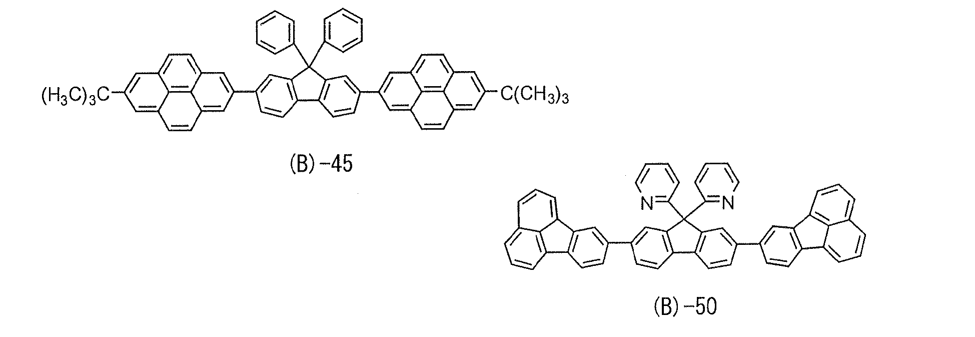

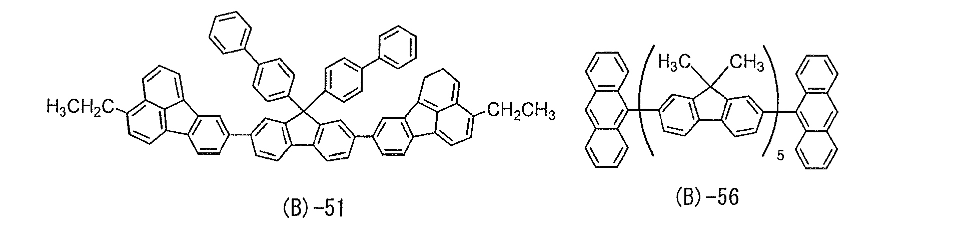

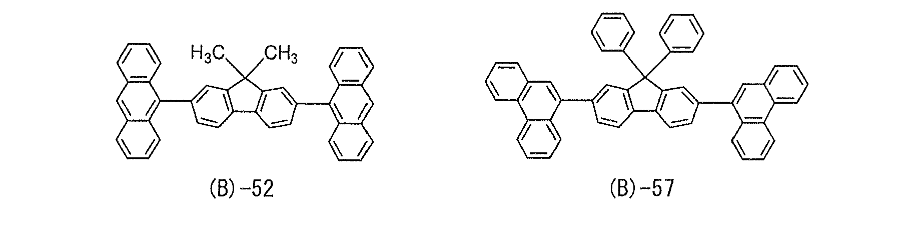

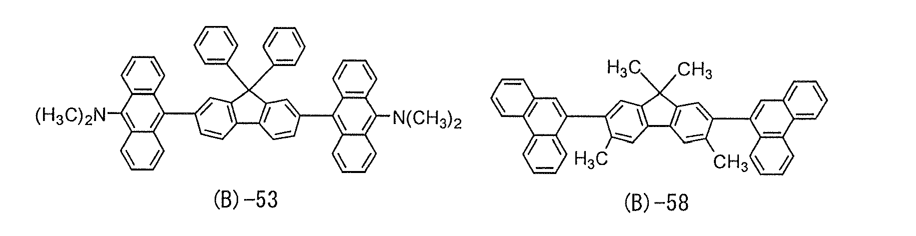

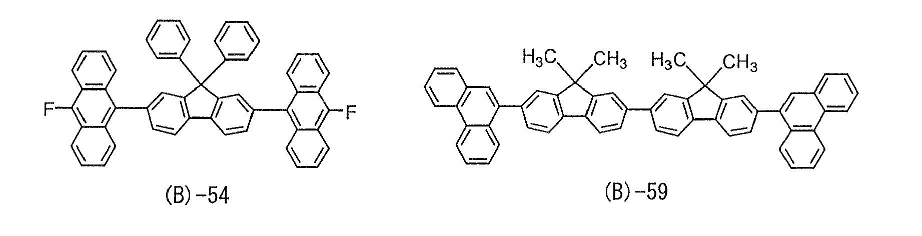

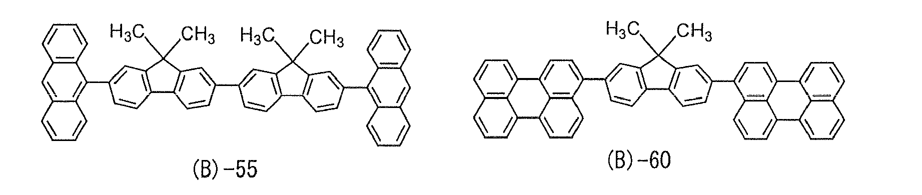

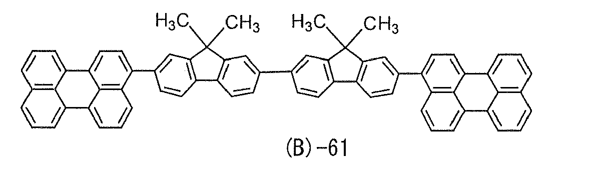

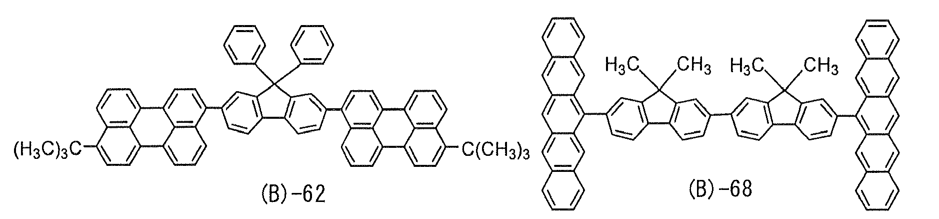

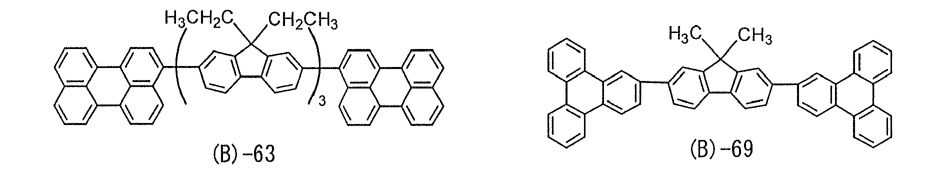

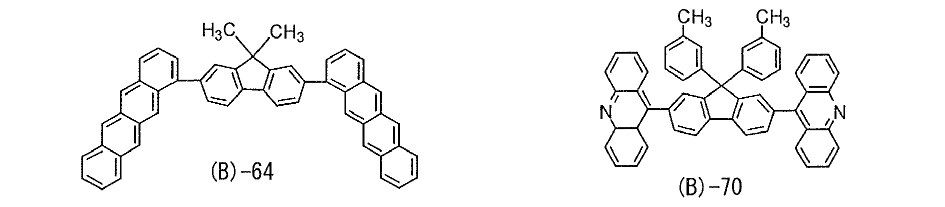

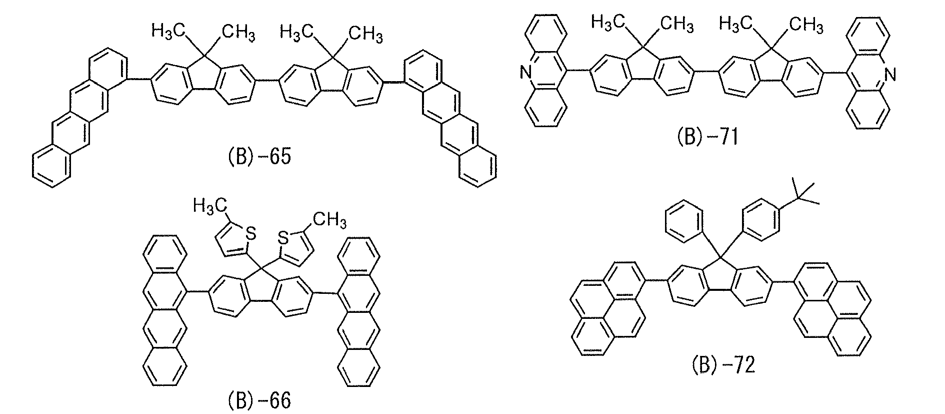

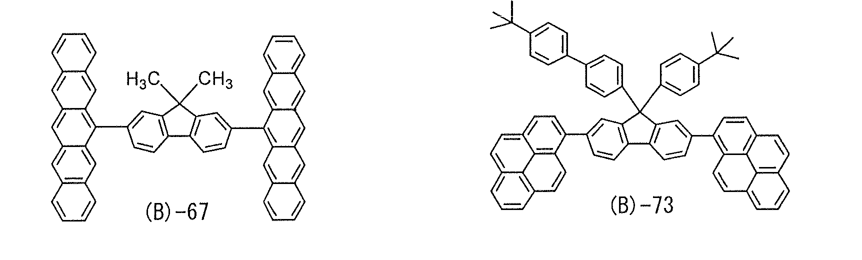

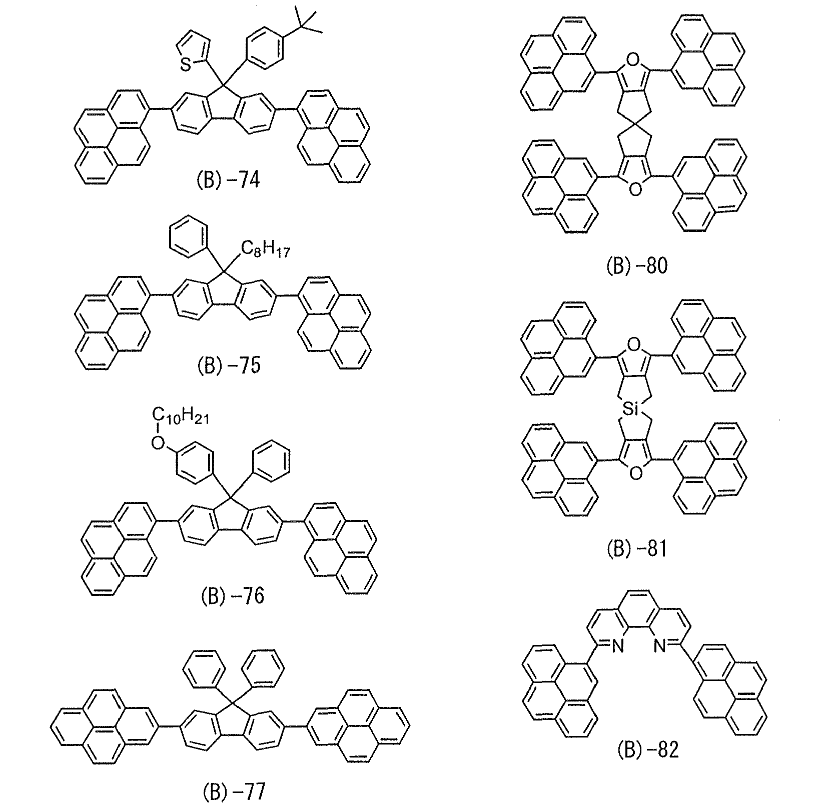

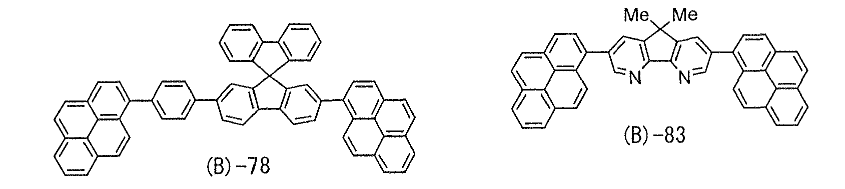

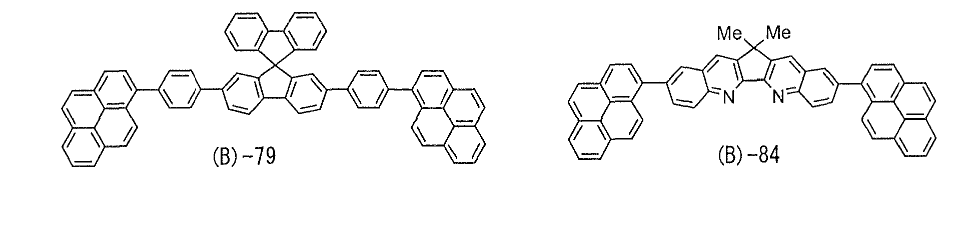

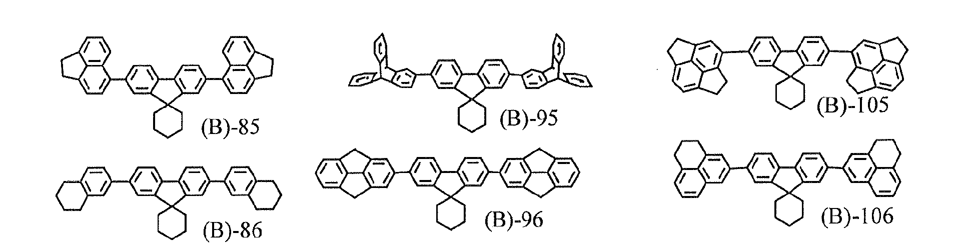

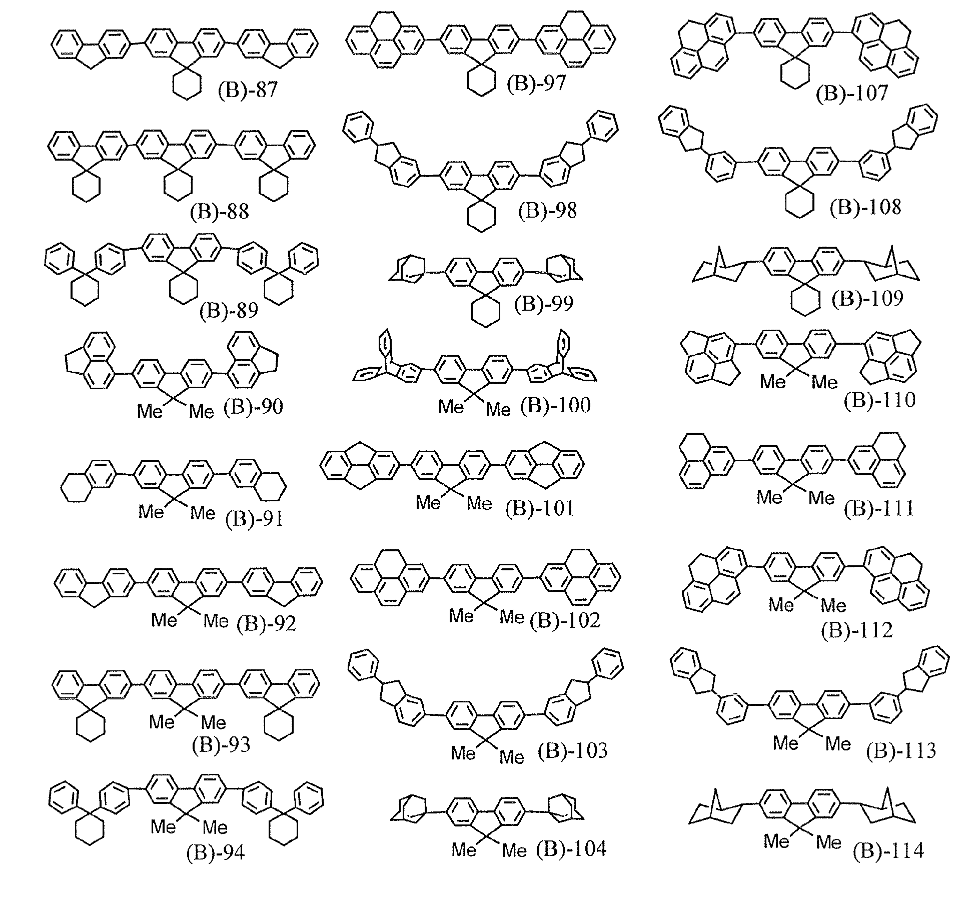

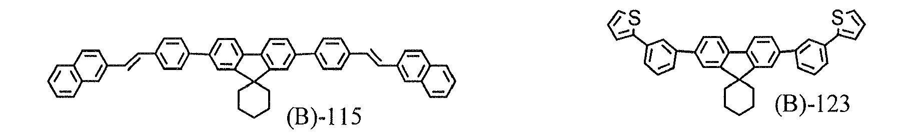

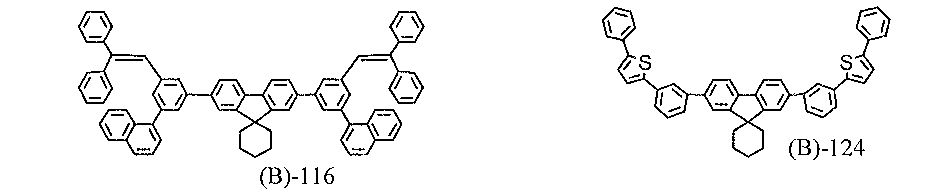

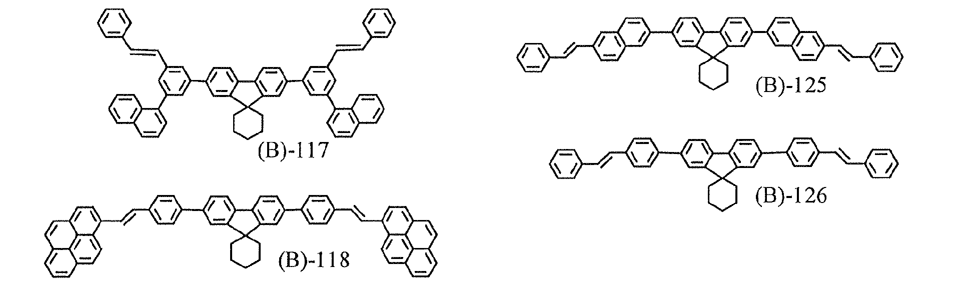

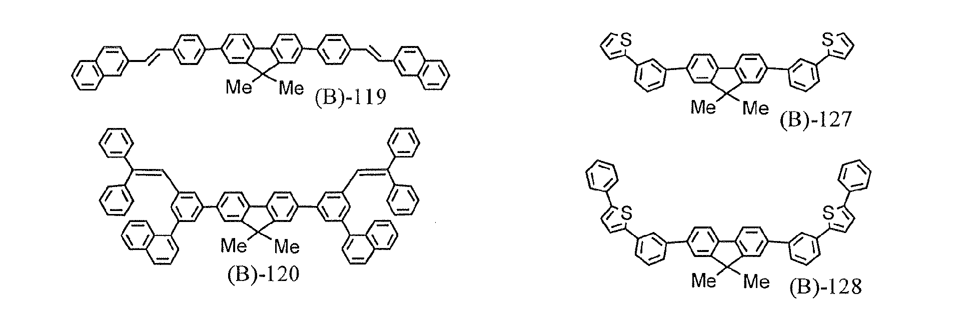

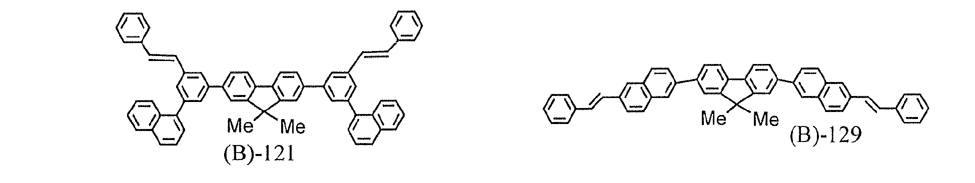

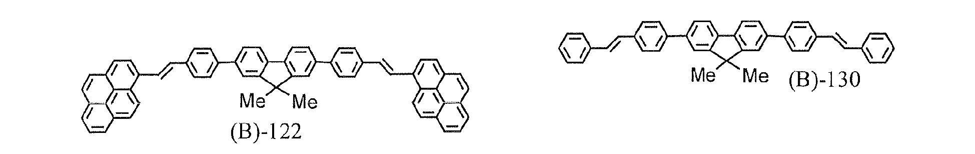

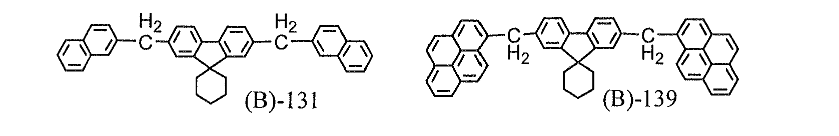

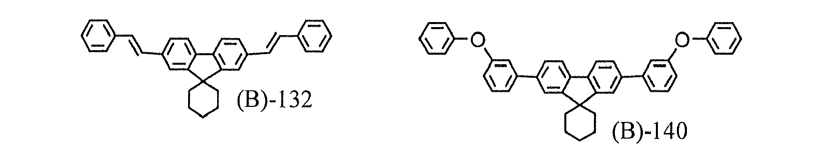

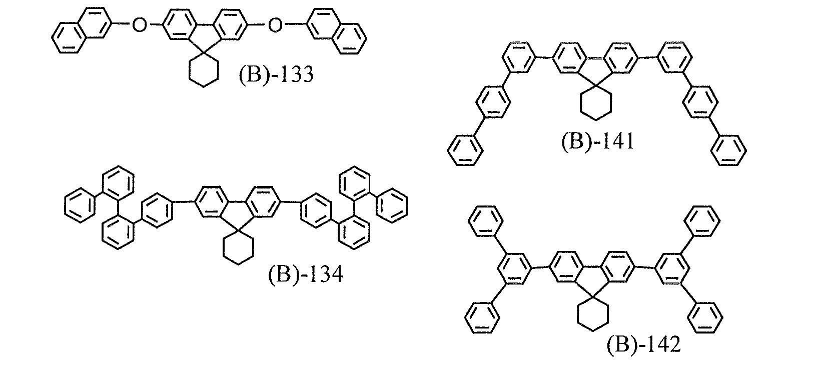

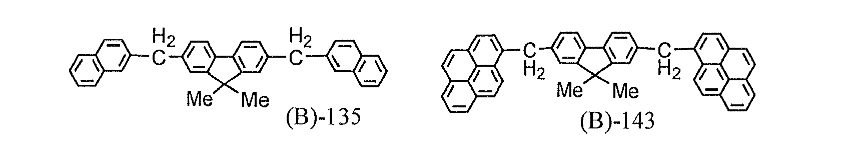

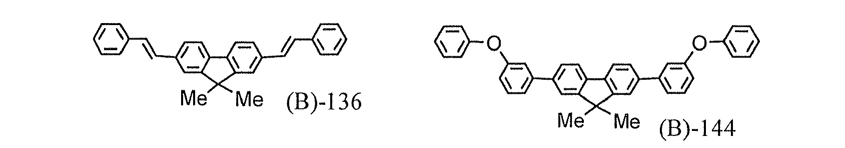

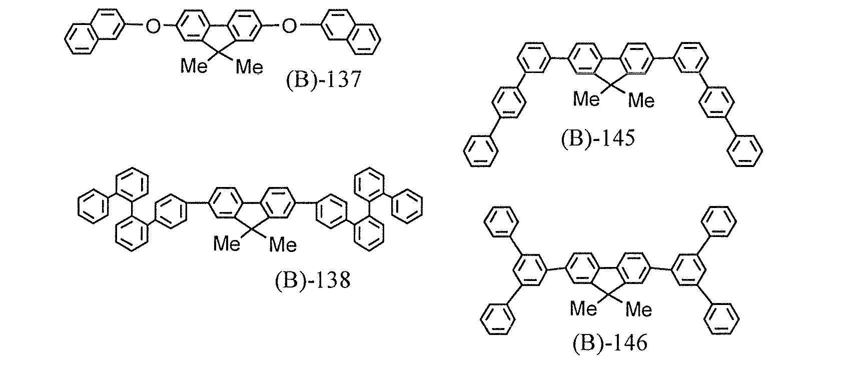

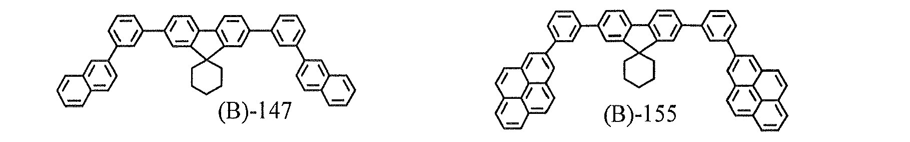

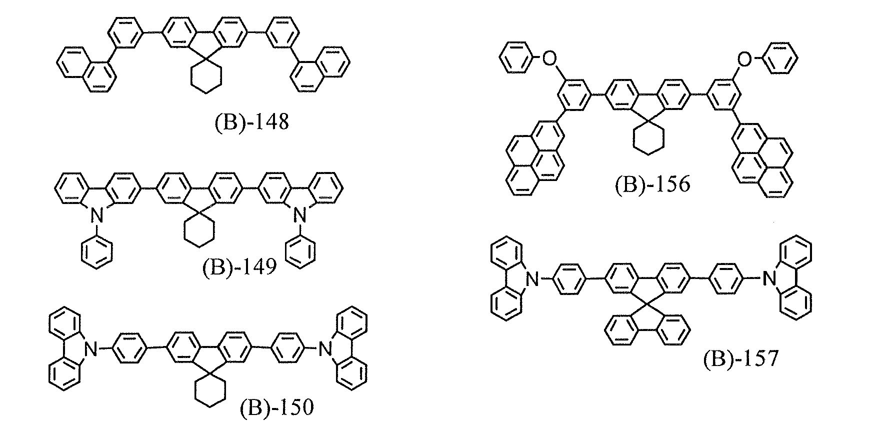

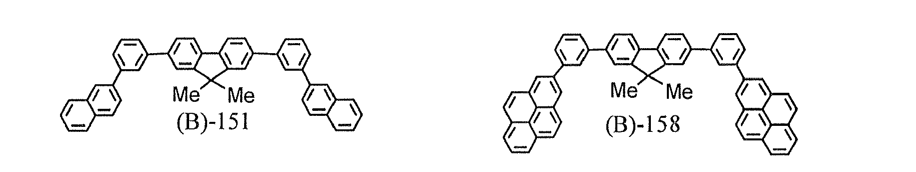

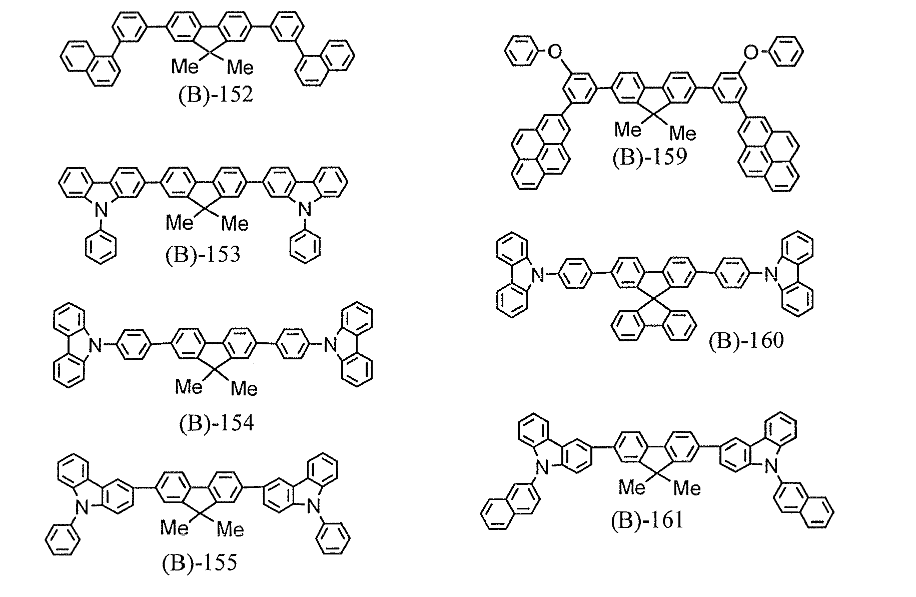

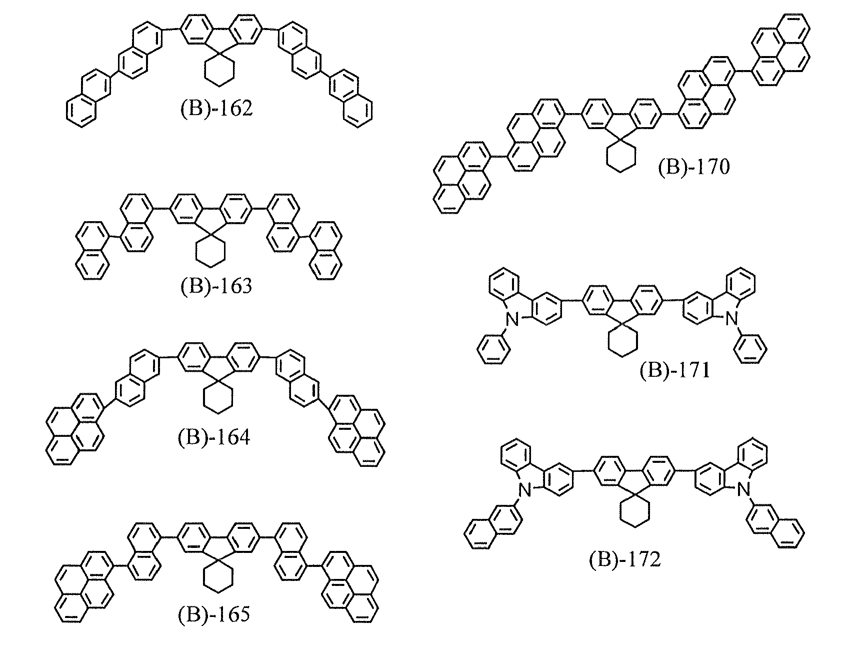

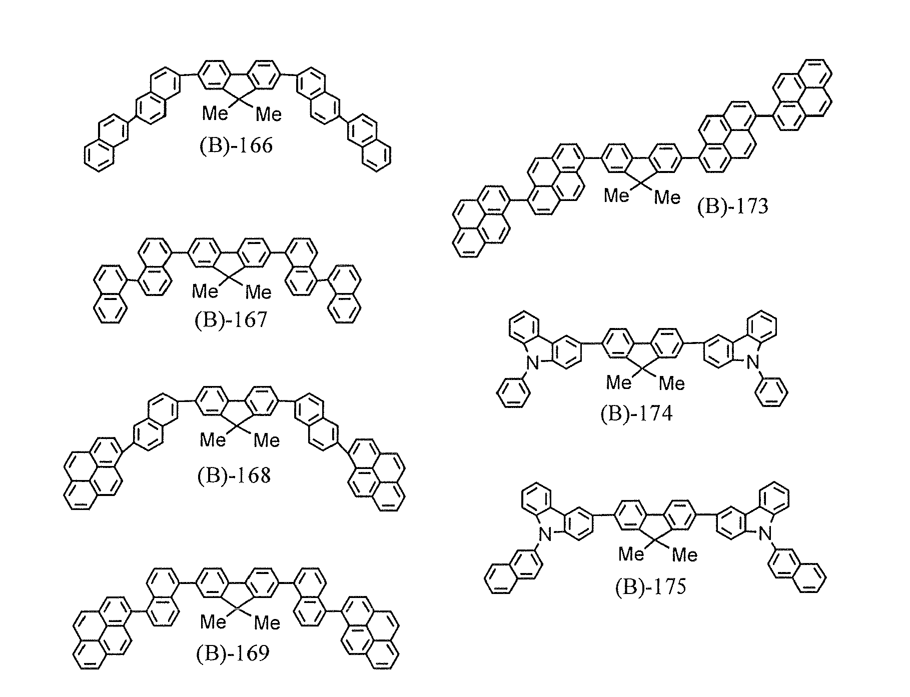

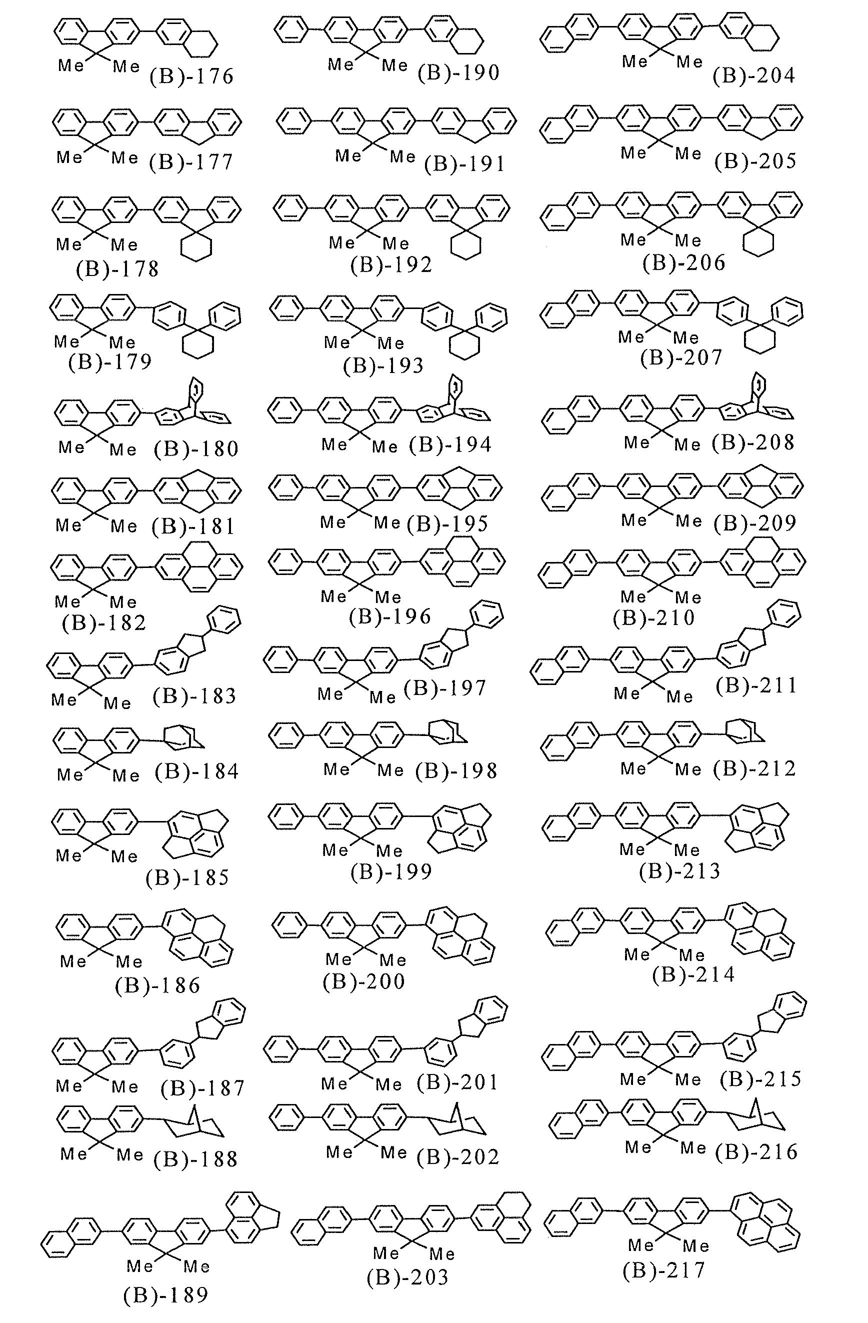

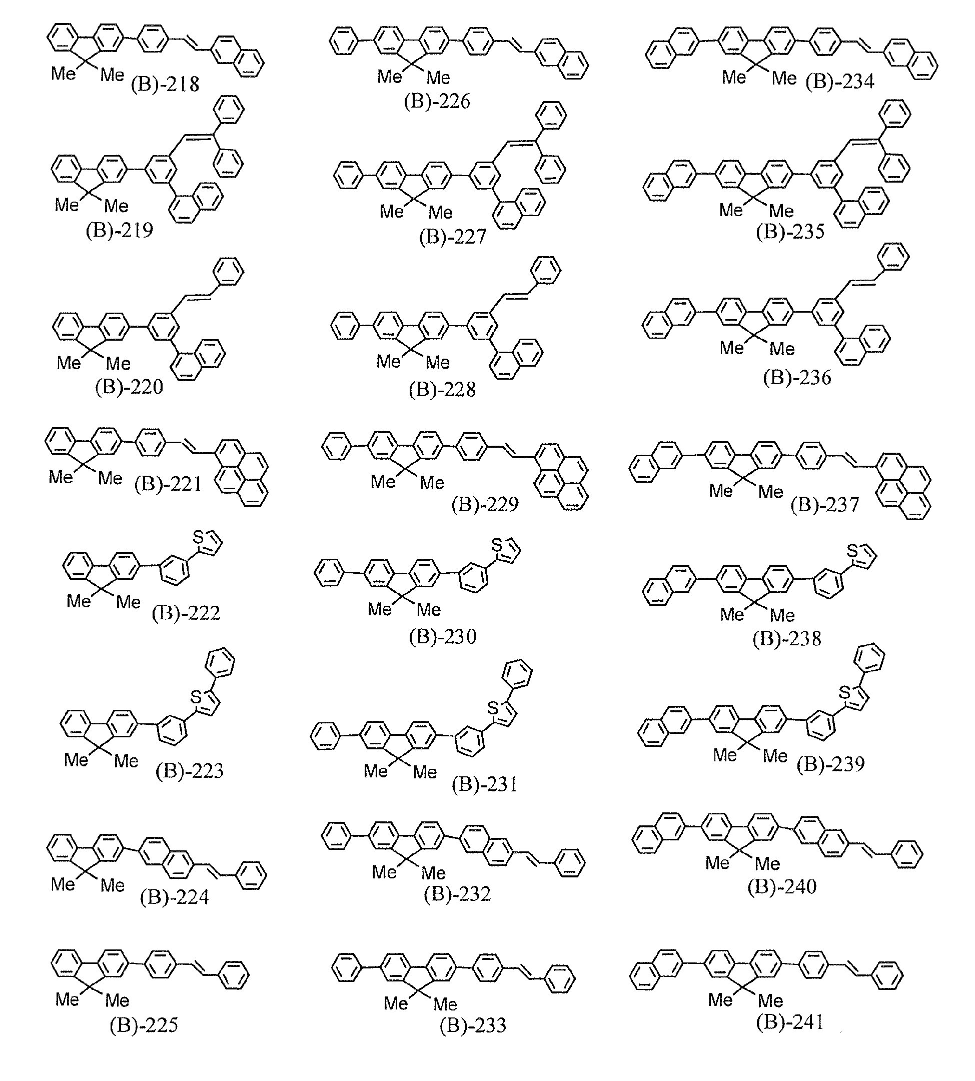

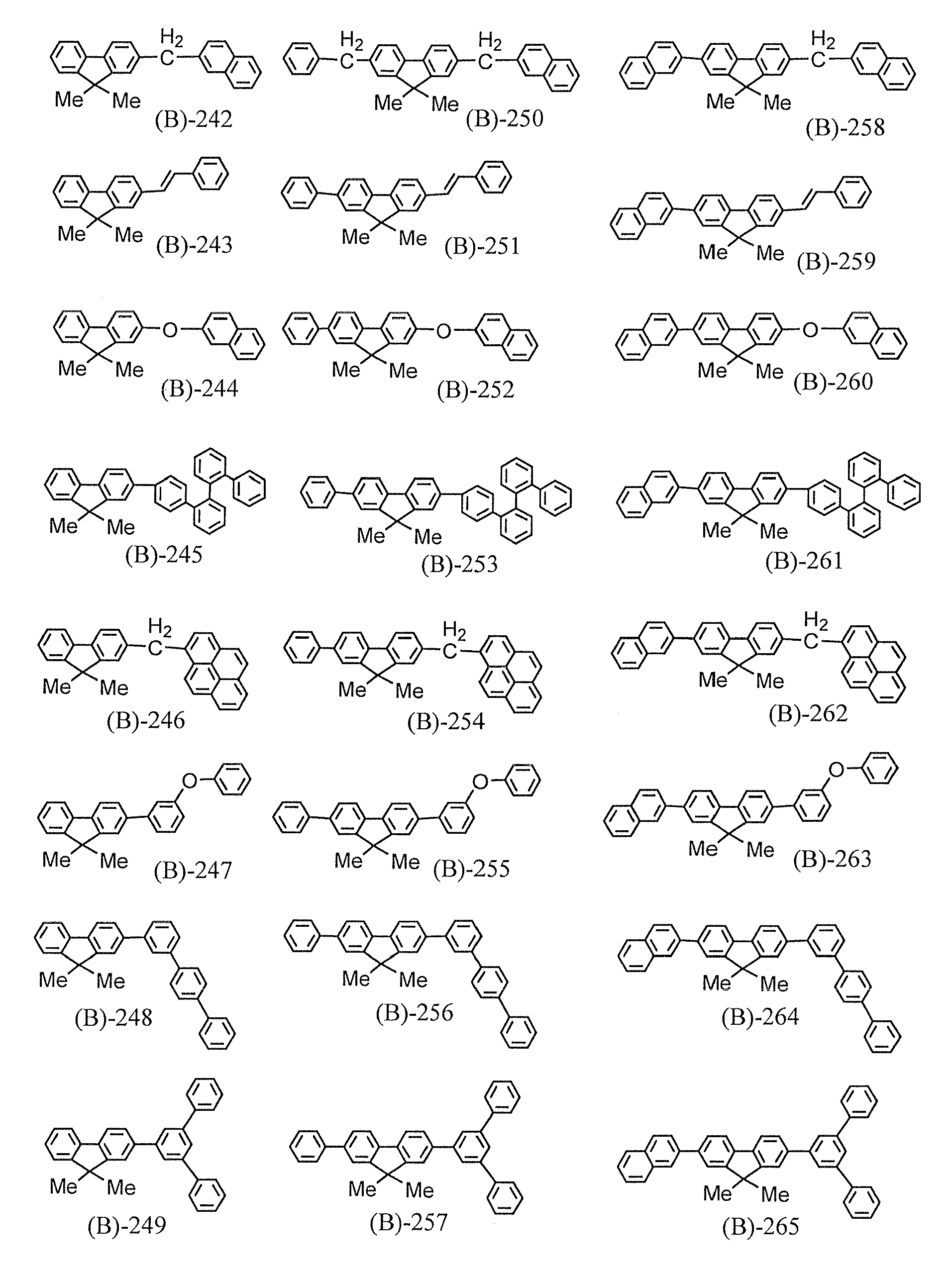

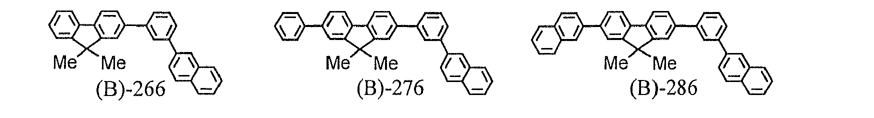

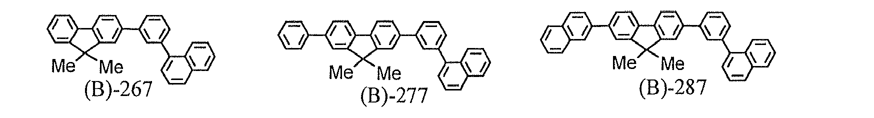

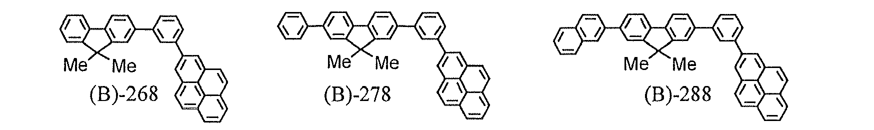

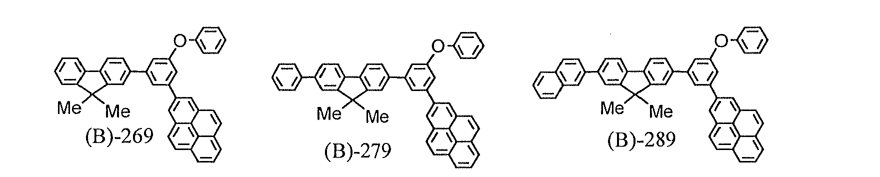

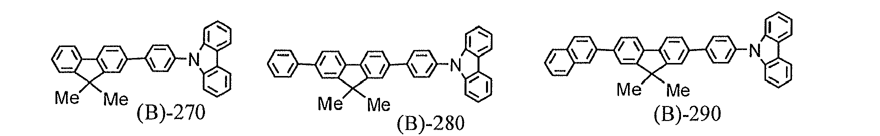

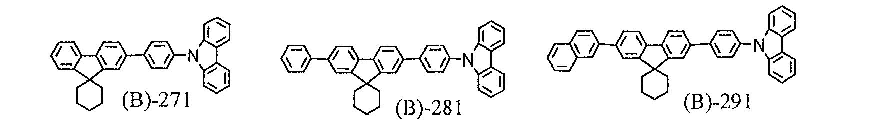

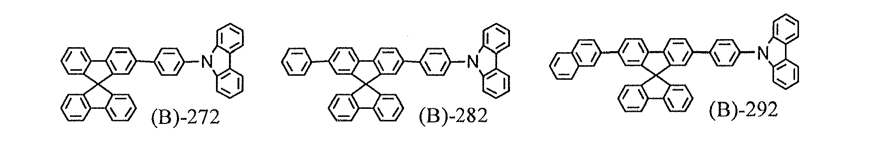

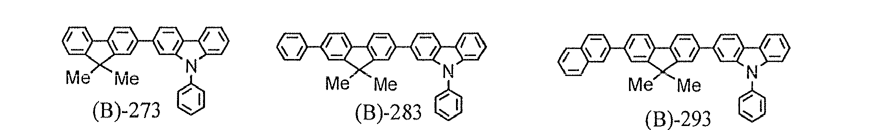

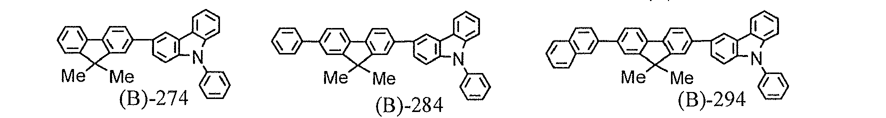

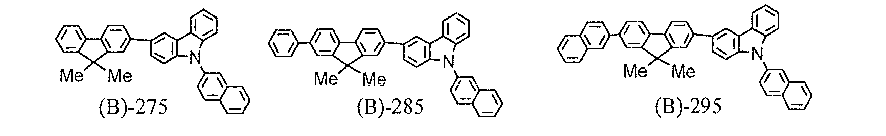

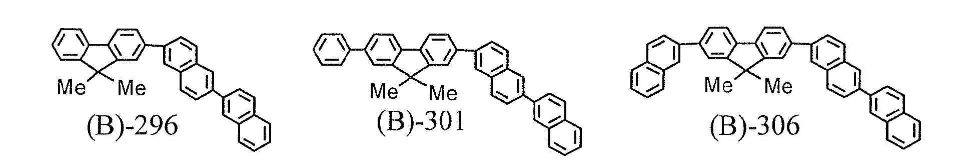

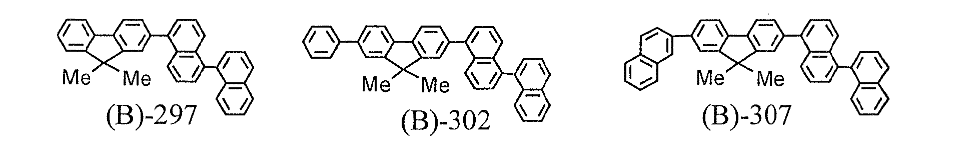

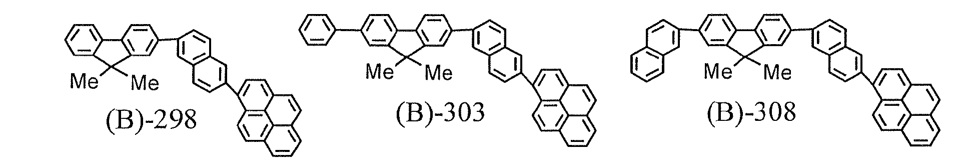

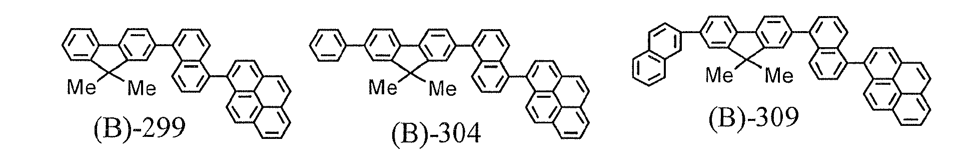

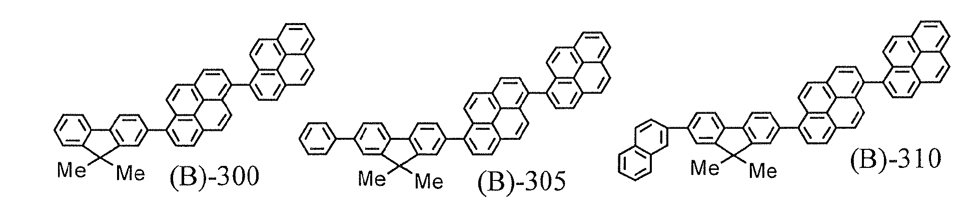

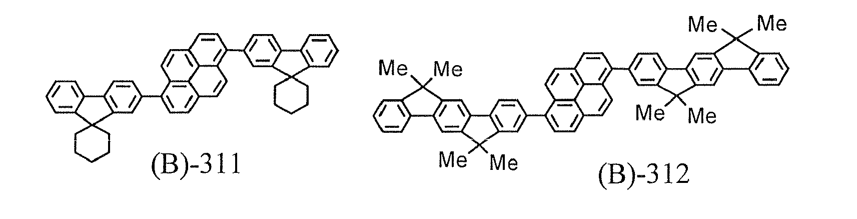

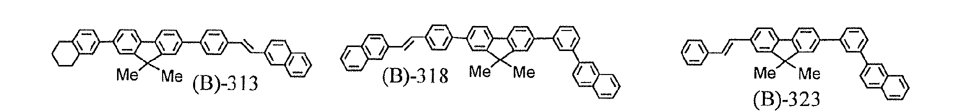

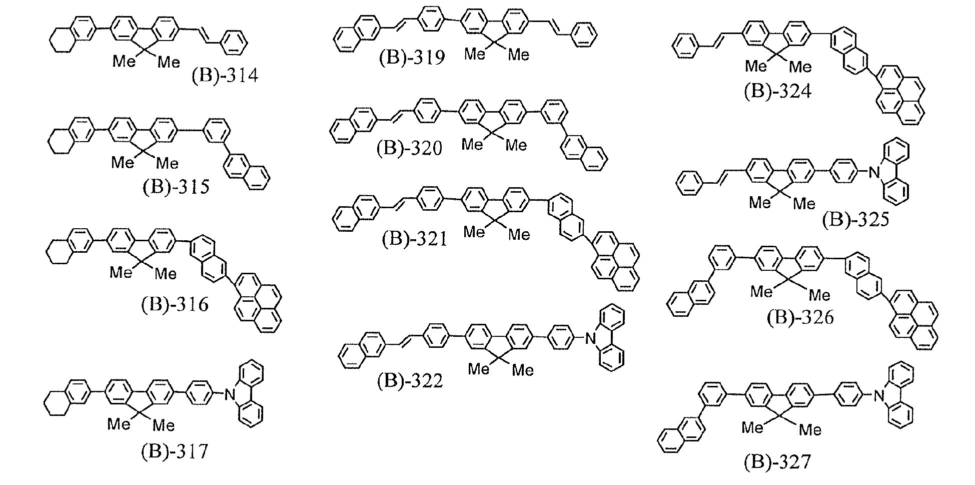

In addition, examples of a substituent of each group explained in the general formulae (A) and (B) include a halogen atom, a hydroxyl group, a substituted or unsubstituted amino group, a nitro group, a cyano group, a substituted or unsubstituted alkyl group, a fluorine-substituted alkyl group, a substituted or unsubstituted alkenyl group, a substituted or unsubstituted cycloalkyl group, a substituted or unsubstituted alkoxyl group, a substituted or unsubstituted heterocyclic group, a substituted or unsubstituted arylalkyl group, a substituted or unsubstituted aryloxy group, a substituted or unsubstituted alkoxycarbonyl group and a carboxyl group.

In the organic EL devices of the present invention, it is preferable that a host material is at least one species selected from the fluorene-based compounds represented by the general formula (B) and that a dopant is at least one species selected from the amine compounds represented by the general formula (A), and it is preferable that the aforementioned light emitting layer comprises the fluorene-based compound and the amine compound at the ratio (% by weight) of from 99.99:0.01 to 80.00: 20.00.
In addition, a color of light emission in the range of from green color to pure red color by the organic EL devices of present invention may be classified by the maximum wavelength of light emission; a blue color has the maximum wavelength of light emission of 410 to 485 nm, a blue-green color has the maximum wavelength of light emission of 485 to 500 nm, a green color has the maximum wavelength of light emission of 500 to 530 nm, a yellow color has the maximum wavelength of light emission of 530 to 585 nm, a orange color has the maximum wavelength of light emission of 585 to 595 nm, a red color has the maximum wavelength of light emission of 595 to 620 nm and a pure red color has the maximum wavelength of light emission of 620 to 700 nm.

An organic EL device of the present invention comprises one or more organic compound layers interposed between a pair of electrode, and a variety of a middle layers is preferably laid between each of the electrodes and the organic compound layer. Examples of the middle layer include a hole injecting layer, a hole transporting layer, an electron injecting layer and an electron transporting layer. For these, a variety of organic compounds and inorganic compounds has been well-known.
Typical examples of the construction of the organic EL device include:
(1) An anode / a light emitting layer / a cathode;
(2) An anode / a hole injecting layer / a light emitting layer / a cathode;
(3) An anode / a light emitting layer / an electron injecting layer / a cathode;
(4) An anode / a hole injecting layer / a light emitting layer / an electron injecting layer / a cathode;
(5) An anode / an organic semiconductor layer / a light emitting layer / a cathode;
(6) An anode / an organic semiconductor layer / an electron barrier layer / a light emitting layer / a cathode;
(7) An anode / an organic semiconductor layer / a light emitting layer / an adhesion improving layer / a cathode;
(8) An anode / a hole injecting layer / a hole transporting layer / a light emitting layer / an electron injecting layer / a cathode;
(9) An anode / an insulating layer / a light emitting layer / an insulating layer / a cathode;
(10) An anode / an inorganic semiconductor layer / an insulating layer / a light emitting layer / an insulating layer / a cathode;
(11) An anode / an organic semiconductor layer / an insulating layer / a light emitting layer / an insulating layer / a cathode;
(12) An anode / an insulating layer / a hole injecting layer / a hole transporting layer / a light emitting layer / an insulating layer / a cathode; and
(13) An cathode / an insulating layer / a hole injecting layer / a hole transporting layer / a light emitting layer / an electron injecting layer / a cathode.
Among the above constructions, construction (8) is preferable. However, the construction of the organic EL device is not limited to the above, as a matter of course.

The organic EL device is generally produced on a substrate which transmits light. The substrate which transmits light is the substrate which supports the organic EL device. It is preferable that the substrate which transmits light has a light transmittance of 50% or greater in the visible region of 400 to 700 nm. It is also preferable that a flat and smooth substrate is employed.
As the substrate which transmits light, for example, glass sheet and synthetic resin sheet are advantageously employed. Specific examples of the glass sheet include soda ash glass, glass containing barium and strontium, lead glass, aluminosilicate glass, borosilicate glass, barium borosilicate glass and quartz. Specific examples of the synthetic resin sheet include sheet made of polycarbonate resins, acrylic resins, polyethylene terephthalate resins, polyether sulfide resins and polysulfone resins.

As the anode, an electrode made of a material such as a metal, an alloy, an electrically conductive compound and a mixture of these materials which has a great work function (4 eV or more) is preferable. Specific examples of the material for the electrode include metals such as Au and electrically conductive materials such as CuI, ITO (indium tin oxide), SnO₂, ZnO and In-Zn-O. The anode can be prepared by forming a thin film of the electrode material described above in accordance with a process such as the vapor deposition process and the sputtering process. When the light emitted from the light emitting layer is obtained through the anode, it is preferable that the anode has a transmittance of the emitted light exceeding 10%. It is also preferable that the sheet resistivity of the anode is several hundreds Ω/□ or smaller. The thickness of the cathode is, in general, selected in the range of from 10 nanometers to 1 µ m and preferably in the range of from 10 to 200 nanometers.

As the cathode, an electrode made of a material such as a metal, an alloy, an electrically conductive compound and a mixture of these materials which has a small work function (4 eV or smaller) is employed. Specific examples of the material for the cathode include sodium, sodium-potassium alloys, magnesium, lithium, magnesium-silver alloys, aluminum/aluminum oxide, Al/Li₂O, Al/LiO₂, Al/LiF, aluminum-lithium alloys, indium and rare earth metals.
The cathode can be prepared by forming a thin film of the electrode material described above in accordance with a process such as the vapor deposition process and the sputtering process.
When the light emitted from the light emitting layer is obtained through the cathode, it is preferable that the cathode has a transmittance of the emitted light greater than 10 %. It is also preferable that the sheet resistivity of the cathode is several hundreds Ω /□ or smaller. The thickness of the anode is, in general, selected from the range of from 10 nanometers to 1/µm and preferably from the range of from 50 to 200 nanometers.

In the organic EL device of the present invention, it is preferable that a layer of a chalcogenide, a metal halide or a metal oxide (this layer may occasionally be referred to as a surface layer) is disposed on the surface of at least one of the pair of electrodes prepared as described above. Specifically, it is preferable that a layer of a chalcogenide (including an oxide) of a metal such as silicon and aluminum is disposed on the surface of the anode at the side of the organic compound layer, and a layer of a metal halide or a metal oxide is disposed on the surface of the cathode at the side of the organic compound layer. Due to the above layers, stability in driving can be improved.
Preferable examples of the above-mentioned chalcogenide include SiOₓ (1≦ x≦2), AlOₓ (1≦x≦1.5), SiON and SiAlON. Preferable examples of the metal halide include LiF, MgF₂, CaF₂ and fluorides of rare earth metals. Preferable examples of the metal oxide include Cs₂O, Li₂O, MgO, SrO, BaO and CaO.

In the organic EL device of the present invention, it is preferable that a mixed region of an electron transfer compound and a reducing dopant or a mixed region of a hole transfer compound and an oxidizing dopant is disposed on the surface of at least one of the pair of electrodes prepared as described above. Due to the mixed region disposed as described above, the electron transfer compound is reduced to form an anion, and injection and transportation of electrons from the mixed region into the light emitting medium can be facilitated. The hole transfer compound is oxidized to form a cation, and injection and transportation of holes from the mixed region into the light emitting medium is facilitated. Preferable examples of the oxidizing dopant include various types of Lewis acid and acceptor compounds. Preferable examples of the reducing dopant include alkali metals, compounds of alkali metals, alkaline earth metals, rare earth metals and compounds of these metals.

In the organic EL device of the present invention, the light emitting layer has the following functions:
(1) The injecting function: the function of injecting holes from the anode or the hole injecting layer and injecting electrons from the cathode or the electron injecting layer when an electric field is applied;
(2) The transporting function: the function of transporting injected charges (electrons and holes) by the force of the electric field; and
(3) The light emitting function: the function of providing the field for recombination of electrons and holes and leading the recombination to the emission of light.
As the process for forming the light emitting layer and the organic compound layer containing the light emitting layer, a well known process such as the vapor deposition process, the spin coating process and the LB process can be employed. It is particularly preferable that the light emitting layer and the organic compound layer are a molecular deposit film. The molecular deposit film is a thin film formed by deposition of a material compound in the gas phase or a thin film formed by solidification of a material compound in a solution or in the liquid phase. Usually, the molecular deposit film can be distinguished from the thin film (the molecular accumulation film) formed in accordance with the LB process by the differences in the aggregation structure and higher order structures or by the functional differences caused by these structural differences.

As disclosed in Japanese Patent Application Laid-Open No. Showa 57(1982)-51781, the organic compound layer can also be formed by dissolving a binder such as a resin and the material compounds into a solvent to prepare a solution, followed by forming a thin film from the prepared solution in accordance with the spin coating process and the like.
In the present invention, where desired, the light emitting layer may contains a publicly known organic compound other than the components of A and B, or a light emitting layer containing the compounds of the present invention may be laminated to a light emitting layer containing a publicly known organic compound, provided that the objective of the present invention is not adversely affected.
For example, the organic EL device may contain not only an amine compound represented by the general formula (A) but also a publicly known fluorescent or phosphorescent dopant.
The fluorescent dopant may preferably be a compound, which is selected from an amine compound, tris(8-qinolinolato)aluminum derivative, a coumarin derivative, tetra-phenyl butadiene derivative, bis-stylylarylene derivative, oxadiazole derivative and the like, to meet a color of light emission to be required.
In addition, the phosphorescent dopant may preferably be a metal-complex compound containing at least a metal selected from Ir, Ru, Pd, Pt, Os and Re, and having at least a bone structure selected from a phenylpyridine bone structure, a bipyridyl bone structure and a phenanthrone bone structure. Examples of the metal complex include tris(2-phenylpyridine) iridium, tris(2-phenylpyridine) ruthenium, tris(2-phenylpyridine) palladium, tris(2-phenylpyridine) platinum, tris(2-phenylpyridine) osmium, tris(2-phenylpyridine) rhenium, octaethylplatinum porphyrin, octapheylplatinum porphyrin, octaethylpalladium porphyrin and octaohenylpalladium porphyrin, but it is not limited thereto, therefore a appropriate metal complex may be selected from the view points of a light-emitting color, a device performance and a host compound to be required.
The thickness of the light-emitting layer is preferably in the range of from 5 to 200 nanometers, most preferably in the range of from 10 to 40 nanometers since an applied voltage can be low particularly.

By combining at least one species selected from the fluorene-based compounds represented by the general formula (B) for a host compound and at least one species selected from the amine compounds for a dopant, and employing the combination for a light emitting layer, the light emitting layer becomes amorphous. Therefore, the crystallization thereof is repressed, the stability is increased and the heat resistance is improved remarkably. Preferable host materials may be the one having a glass transition temperature of 110°C or more. By blending such materials having the glass transition temperature, the glass transition temperature of the light emitting layer can be 110°C or more, therefore it is possible that the layer has a storage heat-resistance for 500 hours or more at 85°C. In addition, it is possible to control chromaticity of a color of light emission and a peak wavelength of a light emission spectrum by controlling the blending ratio between a host material and a dopant. Namely, increasing a dopant ratio therein results in moving a peak of a light-emission spectrum toward a long wavelength. This is due to a long wavelength of a light emission spectrum of the dopant. Therefore, it is possible to realize a color representation in the range of from blue color, green color to red color.

The hole injecting and transporting layer is a layer which helps injection of holes into the light emitting layer and transport the holes to the light emitting region. The layer exhibits a great mobility of holes and, in general, have ionization energy as small as 5.5 eV or smaller. For the hole injecting and transporting layer, a material which transports holes to the light emitting layer at a smaller strength of the electric field is preferable. A material which exhibits, for example, a mobility of holes of at least 10⁻⁶ cm²/V.sec under application of an electric field of from 10⁴ to 10⁶ V/cm is more preferable. A material which is used as such materials, can be selected from materials to be conventionally employed as the charge-transporting material of holes in photoconductive materials and publicly known materials to be employed for the hole-injecting layer in organic EL devices.
To form the hole injecting and transporting layer, a thin film may be formed from the material for the hole injecting layer or the hole transporting layer, respectively, in accordance with a publicly known process such as the vacuum vapor deposition process, the spin coating process, the casting process and the LB process. Although the thickness of the hole-injecting layer and the hole-transporting layer is not particularly limited, the thickness is usually in the range of from 5 nanometers to 5 µm.

The electron injecting and transporting layer is a layer which helps injection of electrons into the light emitting layer and transports electrons to the light emitting region and exhibit a great mobility of electrons. Among the electron injecting layers, an adhesion-improving layer is a layer made of a material exhibiting excellent adhesion with the cathode. As the material for the electron-injecting layer, metal complexes of 8-hydroxyquinoline and derivatives thereof are preferable. Examples of the metal complex of 8-hydroxyquinoline and derivatives thereof include metal chelates of oxinoid compounds including chelates of oxine (in general, 8-quinolinol or 8-hydroxyquinoline). For example, tris(8-quinolinol)aluminum can be employed as the electron injecting material.
In addition, an organic EL device tends to form defects in pixels due to leak and short circuit since an electric field is applied to ultra-thin films. To prevent the formation of the defects, a layer of an insulating thin film may be inserted between the pair of electrodes.

Examples of the material employed for the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide and vanadium oxide. Mixtures and laminates of the above compounds can also be employed.
To produce an organic EL device of the present invention, for example, an anode, a light emitting layer and, where necessary, a hole injecting layer and an electron injecting layer are formed in accordance with the aforementioned process using the aforementioned materials, and a cathode is formed in the last step. An organic EL device may be produced by forming the aforementioned layers in the order reverse to that described above, i.e., the cathode being formed in the first step and the anode being formed in the last step.

An embodiment of the process for producing an organic EL device having a construction in which an anode, a hole injecting layer, a light emitting layer, an electron injecting layer and a cathode are disposed sequentially on a light-transmitting substrate will be described in the following.
On a suitable light-transmitting substrate, a thin film made of a material for the anode is formed in accordance with the vapor deposition process or the sputtering process so that the thickness of the formed thin film is 1 µm or thinner and preferably in the range of 10 to 200 nanometers. The formed thin film is employed as the anode. Then, a hole injecting layer is formed on the anode. The hole injecting layer can be formed in accordance with the vacuum vapor deposition process, the spin coating process, the casting process or the LB process, as described above. The vacuum vapor deposition process is preferable since a uniform film can be easily obtained and the possibility of formation of pin holes is small. When the hole injecting layer is formed in accordance with the vacuum vapor deposition process, in general, it is preferable that the conditions in general are suitably selected in the following ranges: temperature of the deposition source: 50 to 450°C; vacuum level: 10⁻⁷ to 10⁻³ torr; deposition rate: 0.01 to 50 nanometers/second; temperature of the substrate: -50 to 300°C; and film thickness: 5 nanometers to 5 µm; although the conditions of the vacuum vapor deposition are different depending on the employed compound (the material for the hole injecting layer) and the crystal structure and the recombination structure of the hole injecting layer to be formed.

Subsequently, the light-emitting layer is formed on the hole-injecting layer formed above. Also the formation of the light emitting layer can be made by forming the light emitting material according to the present invention into a thin film in accordance with the vacuum vapor deposition process, the sputtering process, the spin coating process or the casting process. The vacuum vapor deposition process is preferable because a uniform film can be easily obtained and the possibility of formation of pinholes is small. When the light-emitting layer is formed in accordance with the vacuum vapor deposition process, in general, the conditions of the vacuum vapor deposition process can be selected in the same ranges as those described for the vacuum vapor deposition of the hole-injecting layer although the conditions are different depending on the used compound. It is preferable that the thickness is in the range of from 10 to 40 nanometers.
Next, the electron-injecting layer is formed on the light-emitting layer formed above. Similarly to the hole injecting layer and the light-emitting layer, it is preferable that the electron-injecting layer is formed in accordance with the vacuum vapor deposition process since a uniform film must be obtained. The conditions of the vacuum vapor deposition can be selected in the same ranges as those for the hole injecting layer and the light-emitting layer.
In the last step, the cathode is formed on the electron-injecting layer, and an organic EL device can be fabricated. The cathode is made of a metal and can be formed in accordance with the vacuum vapor deposition process or the sputtering process. It is preferable that the vacuum vapor deposition process is employed in order to prevent the lower organic layers from damages during the formation of the film.
In the above production of the organic EL device, it is preferable that the above layers from the anode to the cathode are formed successively while the production system is kept in a vacuum after being evacuated.

When a DC voltage is applied on the organic EL device produced in the above manner, if a DC voltage of 3 to 40 V is applied in the condition that the anode is connected to a positive electrode (+) and the cathode is connected to a negative electrode (-), then a light emission is observed. When the connection is reversed, no electric current will pass and no light will emit at all. When an AC voltage is applied on the organic EL device, the uniform light emission is observed only in the condition that the polarity of the anode is positive and the polarity of the cathode is negative. When an AC voltage is applied on the organic EL device, any type of waveform can be employed.

### Examples

The present invention will be described more specifically with reference to examples as follows; however, the present invention is not limited by the examples.

### Example 1 (fabrication of a blue light emission device)

An indium tin oxide transparent electrode (thickness:120 nanometers) was formed on a glass substrate (25×75×1.1mm). The glass substrate was cleaned through irradiation of a UV ray in an ozone atmosphere, and placed in a vacuum vapor deposition apparatus.
On the electrode, 4,4'-bis(N,N-di-(3-tolyl)-4-aminophenyl)-4"-phenyltriphenylamine serving as a hole-injecting layer (thickness:60nm), N, N-bis [4'-(N-(naphtyl-1-yl)-N-phenyl)aminobilhenyl-4-yl]-N-phenylamine (thickness:20nm) were sequentially vapor-deposited, followed by simultaneously vapor-depositing the aforementioned Compound (B)-2 serving as a host material and the aforementioned Compound (A)-51 serving as a dopant (40:2 by weight) thereon, to thereby form a light-emitting layer (thickness: 40 nanometers).
Subsequently, tris(8-hydroxyquinolinato)aluminum serving as an electron-injecting layer (thickness: 20 nanometers) was deposited, followed by sequentially vapor-depositing lithium fluoride (thickness: 0.3 nanometers) and aluminum (thickness: 150 nanometers). The lithium fluoride/aluminum film served as a cathode. Thus, an organic EL device was fabricated.
When the organic EL device was tested by passing electric current, a blue-light emission with an emission luminance of 650cd/m² and a current efficiency of 6.5cd/A was observed at a voltage of 6.2V and a current density of 10mA/cm².
In addition, when the EL device was continuously tested by passing electric current at an initial luminance of 1,000cd/m², the half lifetime was founded to be 2,800 hours. The results were described in Table 1.

### Examples 2 to 7

The procedure of Example 1 was repeated, except that the compounds described in the Table 1 respectively serving as a host material and a dopant which were employed for the light-emitting layer were used, to thereby fabricate organic EL devices. When the fabricated devices were tested by passing electric current in a manner similar to that of Example 1, the results were described in Table 1.

### Comparative Example 1

The procedure of Example 1 was repeated, except that only the Comparative Compound - 1 described below serving as a host material to be employed for the light-emitting layer and the aforementioned Compound (A)-101 to be employed for the dopant were used, to thereby fabricate an organic EL device. When the fabricated device was tested by passing electric current in a manner similar to that of Example 1, the results were described in Table 1. Table 1 shows that each of the emission luminance, the current efficiency and the half lifetime thereof was inferior to those of Example 1 to 7 since any of the fluorene-based compound represented by the general formula (B) serving as a host material was not used, although an amine compound of the general formula (A) serving as a dopant was used.

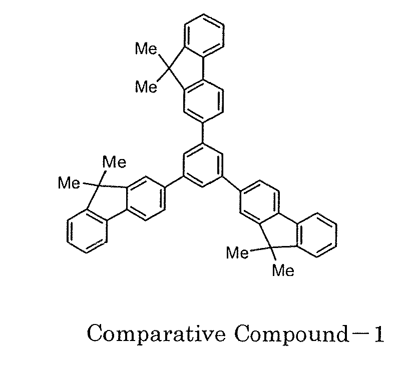

### Comparative Example 2 (an example for a combination of a host compound and a dopant in the patent literature 9)

The procedure of Example 1 was repeated, except that an aforementioned Compound (B)-1 serving as a host material and the Comparative Compound-2 described below serving as a dopant which were employed for the light-emitting layer, were used, to thereby fabricate an organic EL device.
When the fabricated device was tested by passing electric current in a manner similar to that of Example 1, the results were described in Table 1.
Table 1 shows that each of the emission luminance, the current efficiency and the half lifetime thereof was inferior to those of Example 1 to 7 since any of amine compounds of the general formula (A) serving as a dopant was not used, although a fluorene-based compound represented by the general formula (B) serving as a host material was used.

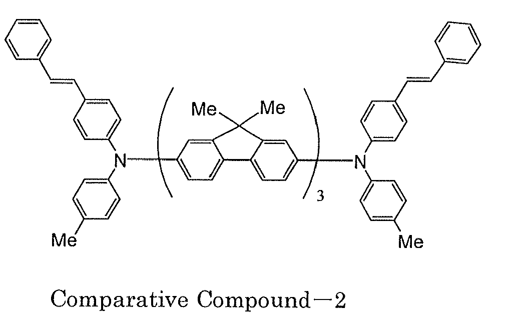

**Table 1**

| | Host Material | Dopant | Driving Voltage (V) | Luminance (cd/m²) | Current Efficiency (cd/A) | Half litemine (hrs) | Color |
|---|---|---|---|---|---|---|---|
| Ex. 1 | (B)-2 | (A)-51 | 6.2 | 650 | 6.5 | 2800 | blue |
| Ex. 2 | (B)-33 | (A)-51 | 6.0 | 600 | 6.0 | 2450 | blue |
| Ex. 3 | (B)-29 | (A)-51 | 5.6 | 620 | 6.2 | 2300 | blue |
| Ex. 4 | (B)-9 | (A)-51 | 6.0 | 610 | 6.1 | 2500 | blue |
| Ex. 5 | (B)-30 | (A)-51 | 6.1 | 600 | 6.0 | 2100 | blue |
| Ex. 6 | (B)-2 | (A)-56 | 5.8 | 630 | 6.3 | 3600 | blue |
| Ex. 7 | (B)-2 | (A)-155 | 5.9 | 650 | 6.5 | 2400 | blue |
| Co. Ex. 1 | Comparative Compound-1 | (A)-101 | 6.5 | 450 | 4.5 | 1200 | blue |
| Co. Ex. 2 | (B)-1 | Comparative Compound-2 | 6.7 | 400 | 4.0 | 900 | blue |

### Example 8 (fabrication of a green light-emitting device)

An indium tin oxide transparent electrode (thickness: 80 nanometers) was formed on a glass substrate (25×75×1.1mm). The glass substrate was cleaned through irradiation of a UV ray in an ozone atmosphere, and placed in a vacuum vapor deposition apparatus.
On the electrode, 4,4'-bis(N,N-di-(3-tolyl)-4-aminophenyl)-4"-phenyltriphenylamine serving as a hole-injecting layer (thickness:60 nanometers), N,N-bis[4'-(N-(diphenylamino)phenyl)-N',N"-diphenylbiphenyl-4,4'-diamine (thickness:20nm) were sequentially vapor-deposited, followed by simultaneously vapor-depositing the aforementioned Compound (B)-1 serving as a host material and the aforementioned Compound (A) -87 serving as a dopant (40:3 by weight) thereon, to thereby form a light-emitting layer (thickness: 40 nanometers).
Subsequently, tris(8-hydroxyquinolinato)aluminum serving as an electron-injecting layer (thickness: 20 nanometers) was deposited, followed by sequentially vapor-depositing lithium fluoride (thickness:0.3 nanometers) and aluminum (thickness:150 nanometers). The lithium fluoride/aluminum film served as a cathode. Thus, an organic EL device was fabricated.
When the organic EL device was tested by passing electric current, a green-light emission with a luminance of 2,040cd/m² and a current efficiency of 20.4cd/A were observed at a voltage of 6.3V and a current density of 10mA/cm². The results were described in Table 2.

### Examples 9 to 15

The procedure of Example 8 was repeated, except that the compounds described in the Table 2 respectively serving as a host material and a dopant, which were employed for the light-emitting layer, were used, to thereby fabricate organic EL devices. When the fabricated devices were tested by passing electric current in a manner similar to that of Example 8, the results were described in Table 1.

### Comparative Example 3

The procedure of Example 8 was repeated, except that only the coumarin derivative described below (3-(2'-benzothiazolyl)-'7-diethylaminocoumarin) serving as a dopant, which was employed for the light-emitting layer, was used, to thereby fabricate an organic EL device. When the fabricated device was tested by passing electric current in a manner similar to that of Example 8, the results were described in Table 2. Table 2 shows that each of the emission luminance, the current efficiency and the half lifetime thereof was inferior to those of Examples 8 to 15 since an amine compound of the general formula (A) serving as a dopant was not used, although any of the fluorene-based compounds represented by the general formula (B) serving as a host material was used.

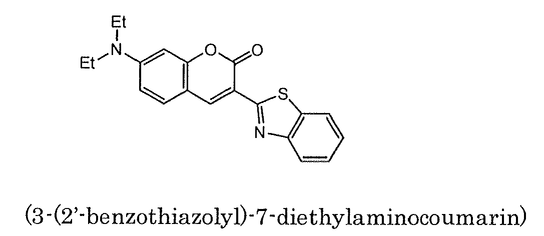

**Table 2**

| | Host Material | Dopant | Driving Voltage (V) | Luminance (cd/m²) (cd/m²) | Current Efficiency (cd/A) | Color |
|---|---|---|---|---|---|---|
| Ex. 8 | (B)-1 | (A)-87 | 6.0 | 2040 | 20.4 | green |
| Ex. 9 | (B)-2 | (A)-87 | 5.9 | 1600 | 16.0 | green |
| Ex. 10 | (B)-33 | (A)-87 | 6.0 | 1760 | 17.6 | green |
| Ex. 11 | (B)-29 | (A)-87 | 6.2 | 1580 | 154.8 | green |
| Ex. 12 | (B)-30 | (A)-88 | 6.1 | 1470 | 14.7 | green |
| Ex. 13 | (B)-30 | (A)-88 | 6.2 | 1840 | 18.4 | green |
| Ex. 14 | (B)-1 | (A)-97 | 6.1 | 1200 | 12.0 | green |
| Ex. 15 | (B)-1 | (A)-100 | 6.3 | 1260 | 12.6 | green |
| Co. Ex. 3 | (B)-1 | Coumarin derivative | 6.5 | 870 | 8.7 | green |

### Example 16 (fabrication of a red light-emitting device)

An indium tin oxide transparent electrode (thickness: 180 nanometers) was formed on a glass substrate (25×75×1.1mm). The glass substrate was cleaned through irradiation of a UV ray in an ozone atmosphere, and placed in a vacuum vapor deposition apparatus.
On the electrode, 4,4'-bis(N,N-di-(3-tolyl)-4-aminophenyl)-4"-phenyltriphenylamine serving as a hole-injecting layer (thickness:60 nanometers), N,N,N',N'-tetrakis(4-biphenyl)-4,4'-benzidine (thickness: 20 nanometers) were sequentially vapor-deposited, followed by simultaneously vapor-depositing the aforementioned Compound (B) - 3 serving as a host material and the aforementioned Compound (A)- 140 serving as a dopant (40:10 by weight) thereon, to thereby form a light-emitting layer (thickness: 40 nanometers).
Subsequently, tris(8-hydroxyquinolinato)aluminum serving as an electron-injecting layer (thickness: 20 nanometers) was deposited, followed by sequentially vapor-depositing lithium fluoride (thickness: 0.3 nanometers) and aluminum (thickness: 150 nanometers). The lithium fluoride/aluminum film served as a cathode. Thus, an organic EL device was fabricated.
When the organic EL device was tested by passing electric current, a green-light emission with a luminance of 450cd/m² and a current efficiency of 4.5cd/A were observed at a voltage of 8.0V and a current density of 10mA/cm². The results were described in Table 3.

### Example 17

The procedure of Example 16 was repeated, except that the compounds described in the Table 3 respectively serving as a host material and a dopant, which were employed for the light-emitting layer, were used, to thereby fabricate organic EL devices.
When the fabricated devices were tested by passing electric current in a manner similar to that of Example 16, the results were described in Table 3.

### Comparative Example 4

The procedure of Example 16 was repeated, except that the Compound (B)-1 serving as a host material and 4-dicyanomethylene-6-julolidinostylyl-2-t-butyl-4H-pyran (DCJTB) respectively serving as a dopant, which were employed for the light-emitting layer were used, to thereby fabricate an organic EL device.
When the fabricated device was tested by passing electric current in a manner similar to that of Example 16, the results were described in Table 3.
Table 3 shows that each of the emission luminance, the current efficiency and the half lifetime thereof was inferior to those of Examples 16 and 17 since any of the amine compounds represented by the general formula (A) serving as a dopant was not used, although a fluorene-based compound represented by the general formula (B) serving as a host material was used.

**Table 3**

| | Host Material | Dopant | Driving Voltage (V) | Luminance (cd/m²) | Current Efficiency (cd/A) | Color |
|---|---|---|---|---|---|---|
| Ex. 16 | (B)-3 | (A)-140 | 8.0 | 450 | 4.5 | red |
| Ex. 17 | (B)-6 | (A)-148 | 8.2 | 420 | 4.2 | pure red |
| Co. Ex. 4 | (B)-1 | DCJTB | 8.5 | 300 | 3.0 | red |

### Example 18

An indium tin oxide transparent electrode formed on a glass substrate (25 × 75 × 1.1mm) was cleaned through ultrasonic wave in isopropyl-alcohol, followed by a UV cleaning in an ozone atmosphere for 30 minutes. The glass substrate after the cleaning was fixed to a substrate holder in a vacuum vapor deposition apparatus, and then the copper phthalocyanine (hereafter sometime called as CuPc film) serving a s hole-injecting layer was deposited on the transparent electrode thereof so as to cover it (thickness: 10 nanometers), followed by vapor-depositing, on the CuPc film, the 4,4'-bis[N-(1-naphthyl)-N-phenylamino] serving as a hole transporting layer biphenyl (herein after sometimes called as α-NPD film, thickness: 30 nanometers). Subsequently, by vapor-depositing, on the α-NPD film, the Compound (B)-154 serving as a host material and simultaneously adding tris(2-phenylpyridine)iridium (hereafter called sometime as Ir(ppy)₃) of a phosphorescent Ir metal complex serving as a dopant thereto, to thereby form a light-emitting layer (thickness:30 nanometers). The concentration of the Ir(ppy)₃ in the light-emitting layer was 5% by weight. Then, a film of (1,1'-biphenyl)-4-olate(bis(2'methyl-8-quinolinolate)aluminum (hereafter sometime called as Balq film) serving as a hole-barrier layer. In addition, tris(8-hydroxyquinohnato)aluminum complex serving as an electron-injecting layer (thickness: 40 nanometers) was vapor deposited (hereafter sometimes called as Alq film), followed by sequentially vapor-depositing lithium fluoride of a alkaline metal halide (thickness: 0.2 nanometers) and aluminum (thickness: 150 nanometers). The lithium fluoride/aluminum film served as a cathode. Thus, an organic EL device was fabricated.
When the organic EL device was tested by passing electric current, a green-light emission of the chromaticity coordinate (0.23, 0.61) with an emission luminance of 101.0 cd/m² and a current efficiency of 38.8 cd/A were observed at a voltage of 5.7 V and a current density of 0.26 mA/cm². In addition, when the EL device with a constant current drive was continuously tested at an initial luminance of 5,000 cd/m², the half lifetime coming to 2500 cd/m² was founded to be 650 hours. Further, the device was tested by passing electric current so as to evaluate a heat resistance thereof under the atmospheric temperature of 105°C, it was found that the device kept a green-light emission having an adequate current efficiency even after passing electric current for 500 hours.

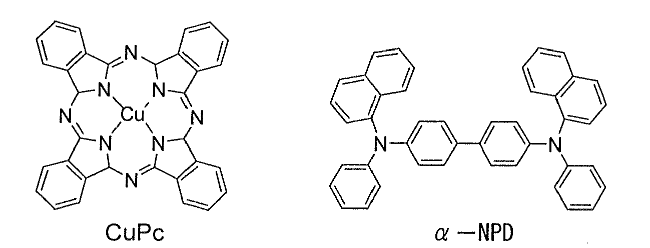

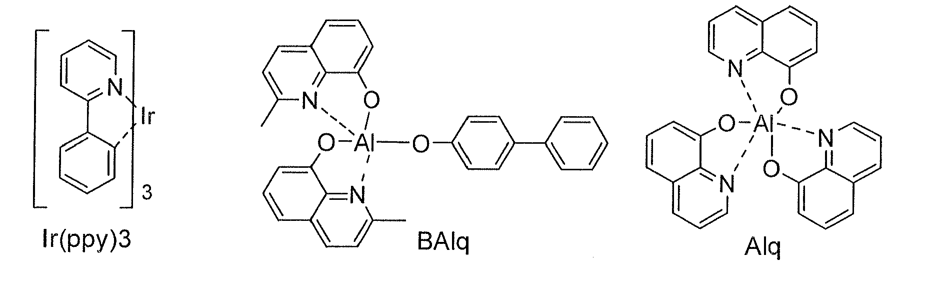

### INDUSRIAL APPLICABILITY

As aforementioned, the EL device exhibits an excellent heat resistance, a prolonged lifetime and a great efficiency of light emission and to produce a light emission in the range of from a blue light to a red light. Therefore, it is useful for a practical organic EL device, particularly suitable for a full color display.

## Claims

1. An organic electroluminescence device comprising one or more thin-film layers which comprise at least a light emitting layer and are interposed between a cathode and an anode, wherein the light emitting layer comprises an amine compound represented by any of the following general formula (A): 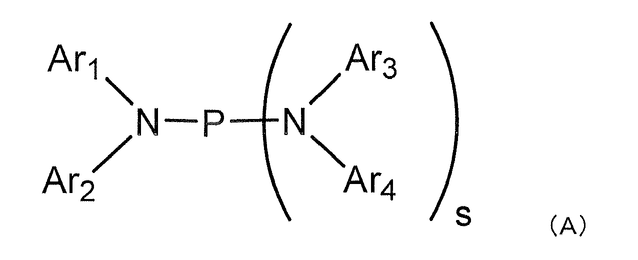 wherein P represents a substituted or unsubstituted aromatic hydrocarbon group having 6 to 40 ring carbon atoms, a substituted or unsubstituted heterocyclic group having 3 to 40 ring atoms, or a substituted or unsubstituted styryl group;
each of Ar₁ to Ar₄ represents a substituted or unsubstituted aromatic hydrocarbon group having 6 to 40 ring carbon atoms, or a substituted or unsubstituted heterocyclic group having 3 to 40 ring atoms and s represents an integer of from 0 to 4; and
a fluorene-based compound represented by the following general formula (B):
(A-X)ₘ-(FL-B)ₙ (B)
wherein m represents an integer of from 0 to 10 and n represents an integer of from 1 to 10;
A represents a substituted or unsubstituted aromatic hydrocarbon group having 6 to 50 ring carbon atoms, a substituted or unsubstituted heterocyclic group having 6 to 50 ring atoms, a substituted or unsubstituted alkyl group or alkylene group having 1 to 50 carbon atoms, or a substituted or unsubstituted alkenyl group or alkenylene group having 1 to 50 carbon atoms, and plural numbers of A may be the same with or different from each other when m is 2 or more;
B represents a single bond, a hydrogen atom, a substituted or unsubstituted aromatic hydrocarbon group having 6 to 50 ring carbon atoms, a substituted or unsubstituted alkyl group or alkylene group having 1 to 50 carbon atoms, or a substituted or unsubstituted alkenyl group or alkenylene group having 1 to 50 carbon atoms, and plural numbers of B may be the same with or different from each other when n is 2 or more;
X represents a single bond, a substituted or unsubstituted aromatic hydrocarbon group having 6 to 50 ring carbon atoms, a substituted or unsubstituted alkylene group having 1 to 50 carbon atoms, or a substituted or unsubstituted alkenylene group having 1 to 50 carbon atoms, and plural numbers of X may be the same with or different from each other when m is 2 or more;
FL represents a fluorene-based derivative group or a group made by combining any of the fluorene-based derivative groups represented by the following general formulae (1) to (6) and plural numbers of FL may be the same with or different from each other when n is 2 or more; 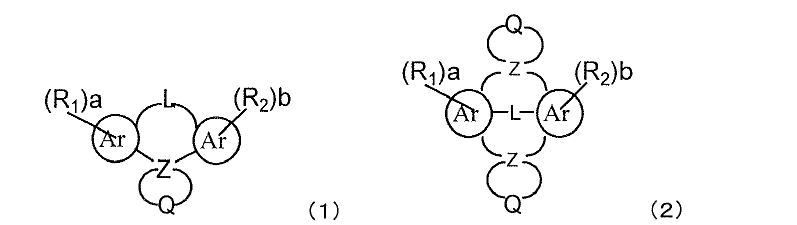 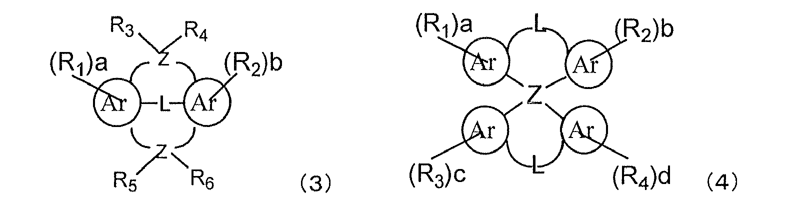 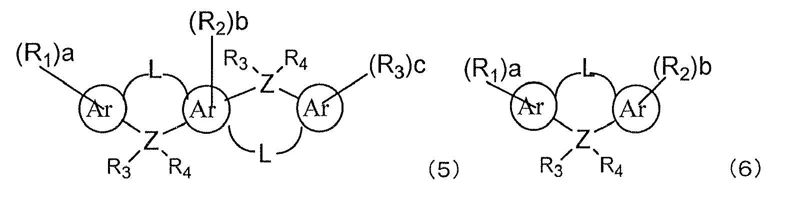 wherein L represents a single bond, -(CR'R")ₖ-, -(SiR'R")ₖ-, -O-, -CO- or -NR'-;
each of R' and R" represents independently a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group or a hydroxyl group, and the members thereof may link each other to form a ring structure; k represents an integer of from 1 to 10 and each of R' and R" may be the same with or different from each other;
Z represents a carbon atom, a silicon atom or a germanium atom;
Q represents a group forming a ring structure and the ring structure comprising Z -Q may be condensed additionally with a substituted or unsubstituted cycloalkyl group having 3 to 50 ring carbon atoms, a substituted or unsubstituted aromatic hydrocarbon group having 5 to 50 ring carbon atoms, or a substituted or unsubstituted heterocyclic group having 5 to 50 ring atoms;
Ar expresses a ring structure shown by a circle enclosing a symbol Ar, and represents a moiety, which may have a substituent, of cycloalkane having 3 to 20 ring carbon atoms of which a carbon atom may be replaced by a nitrogen atom, an aromatic hydrocarbon group having 6 to 50 ring carbon atoms which may have a substituent, or a heterocyclic group having 5 to 50 ring atoms which may have a substituent; and plural numbers of Ar, if any, may be the same with or different from each other;
each of R₁ to R₆ represents a hydrogen atom, a substituted or unsubstituted aromatic hydrocarbon group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 2 to 50 carbon atoms, a carboxyl group, a halogen atom, a cyano group, a nitro group or a hydroxyl group; plural numbers of R₁ to R₆, if any, may be the same with or different from each other and the adjoining ones among R₁ to R₆ may link each other to form a ring structure; and each of a to d is an integer of from 0 to 4..

2. The organic electroluminescence device according to claim 1, wherein the amine compound represented by the general formula (A) is any of the amine compounds represented by the following general formula (A1): 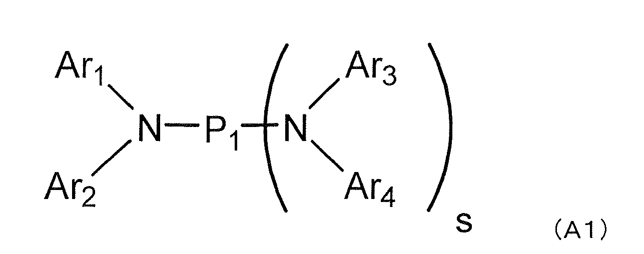 wherein P₁ represents a aromatic hydrocarbon group having 6 to 40 ring carbon atoms, each of Ar₁ to Ar₄ represents independently a substituted or unsubstituted aromatic hydrocarbon group having 6 to 40 ring carbon atoms, or a substituted or unsubstituted heterocyclic group having 3 to 40 ring atoms and s represents an integer of from 0 to 4; and
wherein the FL in the fluorene-based compound represented by the general formula (B) is a group comprising a fluorene-based derivative group represented by any of the above general formulae (1) to (5) or a group made by combining the fluorene-based derivative groups thereof.

3. The organic electroluminescence device according to claim 1, wherein the amine compound represented by the general formula (A) is any of the amine compounds represented by the following general formula (A2): 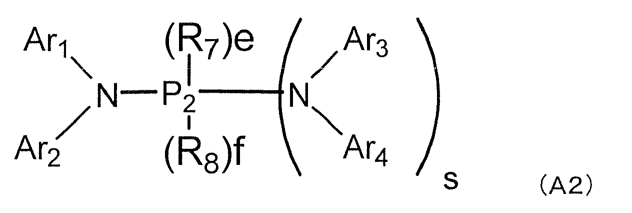 wherein P₂ represents an aromatic hydrocarbon group having 6 to 40 ring carbon atoms;
each of R₇ and R₈ represents independently a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms;
each of e and f represents an integer of from 0 to 5 while e + f ≧ 1, and plural numbers of each of R₇ and R₈ may be the same with or different from each other respectively when each of e and f is 2 or more, and may form a saturated or unsaturated ring structure by linking each other;
each of Ar₁ to Ar₄ represents independently a substituted or unsubstituted aromatic hydrocarbon group having 6 to 40 ring carbon atoms, or a substituted or unsubstituted heterocyclic group having 3 to 40 ring atoms, and s represents an integer of from 0 to 4.

4. The organic electroluminescence device according to claim 1, wherein the amine compound represented by the general formula (A) is any of the amine compounds represented by the following general formula (A3): 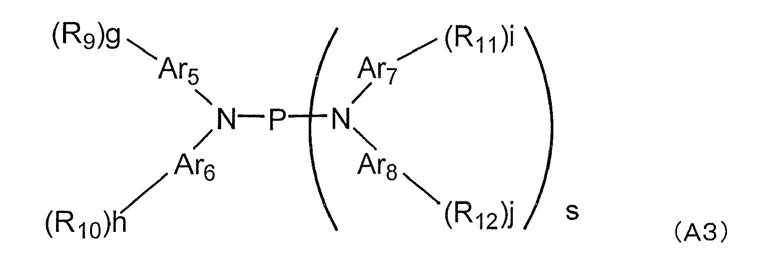 wherein P represents a substituted or unsubstituted aromatic hydrocarbon group having 6 to 40 ring carbon atoms, a substituted or unsubstituted heterocyclic group having 3 to 40 ring atoms, or a substituted or unsubstituted styryl group and s represents an integer of from 0 to 4;
each of R₉ to R₁₂ represents independently a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms;
each of g to j represents an integer of from 0 to 5 while g+h+i+j ≧ 1, plural numbers of each of R₉ to R₁₂ may be the same with or different from each other respectively when each of g to j is 2 or more, and may form a saturated or unsaturated ring structure by linking each other; and
each of Ar₅ to Ar₈ represents independently a substituted or unsubstituted aromatic hydrocarbon group having 6 to 40 carbon atoms or a substituted or unsubstituted heterocyclic group having 3 to 40 carbon atoms.

5. The organic electroluminescence device according to claim 1, wherein the amine compound represented by the general formula (A) is any of the amine compounds represented by the following general formula (A4): 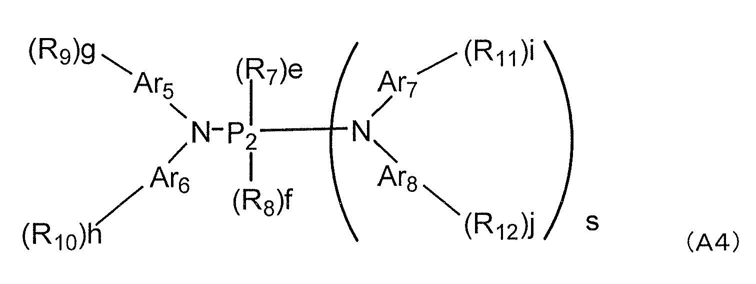 wherein P₂ represents an aromatic hydrocarbon group having 6 to 40 ring carbon atoms and s represents an integer of from 0 to 4;
each of R₇ to R₁₂ represents independently a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms, each of e to j represents an integer of from 0 to 5 while e + f ≧ 1, and g+h+i+j ≧ 1; plural numbers of each of R₇ to R₁₂ may be the same with or different from each other respectively when each of e to j is 2 or more, further may form a saturated or unsaturated ring structure by linking each other; and
each of Ar₅ to Ar₈ represents independently a substituted or unsubstituted aromatic hydrocarbon group having 6 to 40 carbon atoms or a substituted or unsubstituted heterocyclic group having 3 to 40 carbon atoms.

6. The organic electroluminescence device according to claim 4 or claim 5, wherein at least one of each of R₉ to R₁₂ represents a substituted or unsubstituted secondary or tertiary alkyl group having 3 to 10 carbon atoms in the general formulae (A3) and (A4).

7. The organic electroluminescence device according to claims 1 to 5, wherein P in the general formula (A) and (A3), P₁ in the general formula (A1) and P₂ in the general formulae (A2) and (A4) represent a moiety of naphthalene, phenanthrene, fluoranthene, anthracene, pyrene, perylene, chrysene, phenylanthracene or diphenylanthracene, or a moiety made by combining thereof.

8. The organic electroluminescence device according to claim 1, wherein the amine compound represented by the general formula (A) is any of the amine compounds represented by the following general formula (A5): 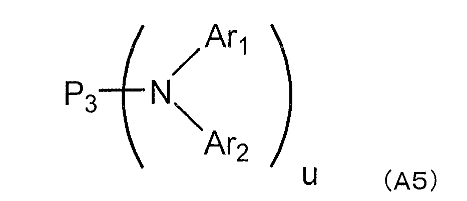 wherein each of Ar₁ and Ar₂ represents the same as aforementioned, u represents an integer of from 1 to 4 and P₃ represents a moiety of any compound represented by the general formula (7): 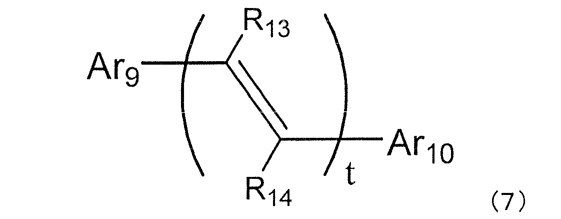 including a substituted or unsubstituted alkenyl structure having 10 to 40 carbon atoms, wherein each of Ar₉ and Ar₁₀ in the general formula (7) represents independently a substituted or unsubstituted aromatic hydrocarbon group having 6 to 40 carbon atoms or a substituted or unsubstituted heterocyclic group having 3 to 40 carbon atoms, each of R₁₃ to R₁₄ represents independently a hydrogen atom, a substituted or unsubstituted alkyl group having 1 to 50 carbon atoms, a substituted or unsubstituted aromatic hydrocarbon group having 5 to 50 ring carbon atoms, a substituted or unsubstituted aralkyl group having 7 to 50 ring carbon atoms, a substituted or unsubstituted cycloalkyl group having 3 to 50 ring carbon atoms, a substituted or unsubstituted alkoxy group having 1 to 50 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 20 carbon atoms, and t represents an integer of from 1 to 4.

9. The organic electroluminescence device according to claim 1, wherein at least one species selected from the fluorene-based compounds represented by the general formula (B) is used as a host material and at least one species selected from the amine compounds represented by the general formula (A) is used as a dopant.

10. The organic electroluminescence device according to claim 1, wherein the light emitting layer thereof comprises any of the fluorene-based compounds and any of the amine compounds at the ratio (% by weight) of from 99.99 : 0.01 to 80.00 : 20.00.

11. The organic electroluminescence device according to claim 1, wherein at least one layer selected from a layer of a chalcogenide, a layer of a metal halide or a layer of a metal oxide is disposed on the surface of at least one of a pair of electrodes.

12. The organic electroluminescence device according to claim 1, wherein the light emitting layer comprises a metal-complex compound.
